# EUROPEAN PATENT APPLICATION

(11) **EP 4 646 065 A1**
(43) Date of publication of application: **05.11.2025**
(21) Application number: 25167760.5
(22) Date of filing: 01.04.2025
(51) Int. Cl.: H10F 19/90, H10F 77/20

(54) **GLUE PRINTING MESH AND PHOTOVOLTAIC MODULE**

(30) Priority: 25.04.2024 CN 202410508483; 25.04.2024 CN 202410510574
(71) Applicant: JINKO SOLAR CO., LTD., Shangrao, Jiangxi 334100 (CN); Jinko Solar (Haining) Co., Ltd., Haining City, Zhejiang 314415 (CN)
(72) Inventor: TAO, Wusong, SHANGRAO 334100 (CN); SHI, Jiale, SHANGRAO 334100 (CN); PENG, Yingying, SHANGRAO 334100 (CN); WANG, Luchuang, SHANGRAO 334100 (CN); JIN, Peng, SHANGRAO 334100 (CN)
(74) Representative: DREISS Patentanwälte PartG mbB

(57) **Abstract**

The present disclosure relates to a glue printing mesh and a photovoltaic module. The glue printing mesh includes an outer frame, a mesh body and mesh holes. The outer frame is arranged at an edge of the mesh body, the mesh body includes a connection region and a glue printing region, the connection region surrounds an outer side of the glue printing region, and the connection region is fixedly connected to the outer frame; and the mesh body further includes a protruding portion, the protruding portion is located on a side of the glue printing region in a thickness direction of the glue printing mesh, and a side of the protruding portion facing away from the mesh body is configured to be in contact with a solar cell. The mesh holes are arranged in the glue printing region, and the mesh holes pass through the mesh body in the thickness direction of the glue printing mesh. Due to the arrangement of the protruding portion, a surface of a side of the glue printing mesh close to the solar cell has a step surface, thereby reducing a risk of glue rubbing of the glue printing mesh, and meanwhile reducing a risk that glue is cured on a surface of a side of the glue printing mesh close to the solar cell, and reducing the risk that the cured glue on the glue printing mesh abuts against an adjacent solar cell to damage the adjacent solar cell, thus improving a yield and production capacity of the photovoltaic module.

## Description

### TECHNICAL FIELD

The present disclosure relates to the technical field of photovoltaic cells and, in particular, to a glue printing mesh and a photovoltaic module.

### BACKGROUND

A photovoltaic module includes a first cover plate, a first adhesive film, a solar cell string, a second adhesive film and a second cover plate which are stacked in a thickness direction of the photovoltaic module, the solar cell string is formed by electrically connecting a plurality of solar cells, a plurality of fingers are provided at a surface of the solar cell, and the fingers of adjacent solar cells are connected to each other through a solder strip, to realize a series connection or parallel connection of the adjacent solar cells. When no busbar is provided at the surface of the solar cell, the solder strip needs to be fixed to the surface of the solar cell in advance by welding, and then the solder strip and the solar cell are fixed by printing glue.

Glue printing is implemented by a glue printing device, the glue printing device includes a base configured to bear the solar cell, a glue printing mesh mounted at the base, and a scraper mounted at the base. The solar cell and the scraper are located at two sides of the glue printing mesh, and the scraper is configured to press down the glue printing mesh and scrape the glue at the glue printing mesh into mesh holes.

In a current production process, after glue is printed at a first solar cell, the first solar cell moves to a curing position, and meanwhile, a second solar cell moves to a glue printing position, and glue is printed at the second solar cell by the glue printing mesh. Meanwhile, the glue printing mesh printed plate is pressed by the scraper and deformed, the glue at the first solar cell is in secondary contact with the glue printing mesh, at this moment, the glue at the first solar cell is not completely cured, so the glue at the first solar cell is rubbed to a bottom of the glue printing mesh, thereby rubbing off the glue at the first solar cell. Meanwhile, the glue rubbed to the bottom of the glue printing mesh is cured under an action of heat or light emitted nearby, and after continuous glue rubbing and curing, more and more glue rubbed to the bottom of the screen is accumulated and hardened, thereby crushing the solar cell by the cured rubbed glue in the following glue printing process, and finally resulting in an extremely low yield of the photovoltaic module to influence the production capacity.

### SUMMARY

The present disclosure provides a glue printing mesh and a photovoltaic module, which can reduce a risk of glue rubbing of a glue printing mesh, to improve the yield and production capacity of a photovoltaic module.

In a first aspect, the present disclosure provides a glue printing mesh, including: an outer frame; a mesh body; and mesh holes. The outer frame is arranged at an edge of the mesh body, the mesh body includes a connection region and a glue printing region, the connection region surrounds an outer side of the glue printing region, and the connection region is fixedly connected to the outer frame; and the mesh body includes a protruding portion, the protruding portion is located on a side of the glue printing region in a thickness direction of the glue printing mesh, and a side of the protruding portion facing away from the mesh body is configured to be in contact with a solar cell. The mesh holes are formed in the glue printing region, and the mesh holes pass through the mesh body in the thickness direction of the glue printing mesh.

In the present disclosure, a surface of a side of the glue printing mesh close to the solar cell has a step surface, and when the protruding portion abuts against one solar cell in the third direction, a certain gap exists between the glue printing mesh and an adjacent solar cell 10 in the third direction, so that a risk that the glue printing mesh abuts against the adjacent solar cell is reduced, and a risk that the uncured glue on the adjacent solar cell adheres to a surface of the glue printing mesh is reduced, that is, a risk of glue rubbing of the glue printing mesh is reduced, thereby improving consistency of an actual glue printing amount and a theoretical glue printing amount of the adjacent solar cell; meanwhile, a risk that the glue is cured on a surface of a side of the glue printing mesh close to the solar cell is reduced, thereby reducing a risk that the cured glue on the glue printing mesh abuts against the adjacent solar cell to damage the adjacent solar cell, thus improving a processing yield of the solar cell and improving a yield and production capacity of the photovoltaic module.

In a possible design, in the thickness direction of the glue printing mesh, a part of the glue printing region protrudes from the outer frame to form the protruding portion; the outer frame includes a first portion and a second portion, and the first portion and the second portion are located at two sides of the mesh body in a first direction; the first portion is provided with a first surface, the second portion is provided with a second surface, the glue printing region is provided with a third surface, and in the thickness direction of the glue printing mesh, the first surface, the second surface and the third surface are all located on a side of the glue printing mesh facing the solar cell; and a height difference H1 between the third surface and the first surface in the thickness direction of the glue printing mesh satisfies: 0<H1≤300 µm, and a height difference H2 between the third surface and the second surface in the thickness direction of the glue printing mesh satisfies: 0≤H2≤300 µm.

In a possible design, in the first direction, on a side close to the first portion, a distance L1 between an edge of the glue printing region and the mesh hole closest to the edge of the glue printing region satisfies: 2 mm≤L1≤7 mm; and in the first direction, on a side close to the second portion, a distance L2 between an edge of the glue printing region and the mesh hole closest to the edge of the glue printing region satisfies: 2 mm≤L2≤7 mm, or 60 mm≤L2≤65 mm.

In a possible design, the mesh body includes a protruding rib, the protruding rib is located on a side of the glue printing region close to the solar cell in the thickness direction of the glue printing mesh, the mesh holes pass through the glue printing region and the protruding rib, and the protruding rib is the protruding portion; and a height of the protruding rib ranges from 200 µm to 350 µm in the thickness direction of the glue printing mesh.

In a possible design, the outer frame includes a first portion and a second portion, and the first portion and the second portion are located at two sides of the mesh body in a first direction; in the first direction, on a side close to the first portion, a distance L1 between an edge of the glue printing region and the mesh hole closest to the edge of the glue printing region satisfies: 60 mm≤L1≤65 mm; and in the first direction, on a side close to the second portion, a distance L2 between an edge of the glue printing region and the mesh hole closest to the edge of the glue printing region satisfies: 60 mm≤L2≤65 mm.

In a possible design, a surface of the protruding portion is covered by a hydrophobic coating.

In a possible design, the outer frame includes a first portion and a second portion, and the first portion and the second portion are located at two sides of the mesh body in a first direction; the mesh holes include a first hole channel, a second hole channel and third hole channels; and in the first direction, the first hole channel is located on a side of the glue printing region close to the first portion, the second hole channel is located on a side of the glue printing region close to the second portion, the third hole channels are arranged at intervals and located between the first hole channel and the second hole channel; a length of the first hole channel in the first direction ranges from 6 mm to 9 mm, and/or a length of the second hole channel in the first direction ranges from 6 mm to 9 mm; or the mesh holes further include a fourth hole channel and a fifth hole channel; and in the first direction, the fourth hole channel and the fifth hole channel are located between the first hole channel and the second hole channel, the third hole channels are located between the fourth hole channel and the fifth hole channel, a length of the first hole channel in the first direction ranges from 0.2 mm to 0.4 mm, a length of the fourth hole channel in the first direction ranges from 0.2 mm to 0.4 mm, a length of the second hole channel in the first direction ranges from 0.2 mm to 0.4 mm, and a length of the fifth hole channel in the first direction ranges from 0.2 mm to 0.4 mm.

In a possible design, the mesh holes are arranged at intervals in the first direction to form unit rows, and the unit rows are arranged at intervals in a second direction; four or more mesh holes are provided in each unit row of the unit rows; and the glue printing mesh has a central axis extending along the first direction, and the unit rows are symmetrically distributed about the central axis.

In a second aspect, the present disclosure provides a photovoltaic module formed by using the glue printing mesh according to any one of the above descriptions.

In a possible design, the photovoltaic module includes at least one solar cell string, and one of the at least one solar cell string includes solar cells, solder strips and glue dots. Adjacent solar cells are electrically connected to each other through the solder strips, the solder strips each extend along a first direction, the plural solder strips are arranged at intervals along a second direction, the solar cells are provided with solder points, the solar cells and the solder strips are soldered and fixed at the solder points, a part of at least one of the glue dots is located on a surface of one of the solar cells and another part of the at least one of the glue dots is located on a surface of one of the solder strips, in such a manner that the solar cells and the solder strips are bonded and fixed at the glue dots, and a plurality of glue dots of the glue dots are arranged in the first direction; the solder points include a first solder point and a second solder point, and along the first direction, the first solder point and the second solder point are located on two sides of one of the solar cells, and at least one of the glue dots is located between the first solder point and the second solder point; the solder strips include at least a first solder strip and a second solder strip arranged along the second direction, and at least one of the glue dots on the first solder strip is not aligned with at least one of the glue dots on the second solder strip in the second direction; and the first solder points on adjacent solder strips are directly opposite to each other in the second direction, and the second solder points on the adjacent solder strips are directly opposite to each other in the second direction.

In a possible design, the glue dots include at least a first glue dot, a second glue dot and third glue dots. In the first direction, the third glue dots are arranged at intervals and located between the first glue dot and the second glue dot; in the first direction, the first glue dot is located at a side of the first solder point facing away from the second solder point, or the first glue dot is located between the first solder point and the second solder point; or in a third direction, at least part of the first glue dot is located above the first solder point; and/or in the first direction, the second glue dot is located at a side of the second solder point facing away from the first solder point, or the second glue dot is located between the first solder point and the second solder point; or in a third direction, at least part of the second glue dot is located above the second solder point.

In a possible design, the first glue dot on the first solder strip is directly opposite to the first glue dot on the second solder strip in the second direction, and/or the second glue dot on the first solder strip is directly opposite to the second glue dot on the second solder strip in the second direction; the third glue dots on the first solder strip are not aligned with the third glue dots on the second solder strip in the second direction; and the third glue dots are evenly distributed between the first glue dot and the second glue dot, and a number N1 of the third glue dots arranged in the first direction satisfies: 4≤N1≤21.

In a possible design, a length of the first glue dot in the first direction ranges from 6 mm to 9 mm, and/or a length of the second glue dot in the first direction ranges from 6 mm to 9 mm; or, the glue dots further include a fourth glue dot and a fifth glue dot, and in the first direction, the fourth glue dot and the fifth glue dot are located between the first glue dot and the second glue dot, and the third glue dots are located between the fourth glue dot and the fifth glue dot; and a length of the first glue dot in the first direction ranges from 0.2 mm to 0.4 mm, a length of the fourth glue dot in the first direction ranges from 0.2 mm to 0.4 mm, a distance between the first glue dot and the fourth glue dot in the first direction ranges from 6 mm to 9 mm, a length of the second glue dot in the first direction ranges from 0.2 mm to 0.4 mm, a length of the fifth glue dot in the first direction ranges from 0.2 mm to 0.4 mm, and a distance between the second glue dot and the fifth glue dot in the first direction ranges from 6 mm to 9 mm.

In a possible design, a number N2 of the solder strips arranged in the second direction satisfies: 14≤N2≤16; in the first direction, a distance S1 between the first solder point and an edge of the solar cell satisfies: 7 mm≤S1≤8 mm, in the second direction, a distance S2 between the first solder point and AN edge of the solar cell satisfies: 7 mm≤S2≤8 mm; and/or in the first direction, a distance S3 between the second solder point and an edge of the solar cell satisfies: 7 mm≤S3≤8 mm, and in the second direction, a distance S4 between the second solder point and an edge of the solar cell satisfies: 7mm≤S4≤8mm.

In a possible design, in the first direction, the first glue dot is located at a side of the first solder point facing away from the second solder point, or the first glue dot is located between the first solder point and the second solder point, and a distance S5 between the first glue dot and the first solder point satisfies: 1 mm≤S5≤2 mm; and/or in the first direction, the second glue dot is located at a side of the second solder point facing away from the first solder point, or the second glue dot is located between the first solder point and the second solder point, and a distance S6 between the second glue dot and the second solder point satisfies: 1 mm≤S6≤2 mm.

It should be understood that the general description above and the detailed description in the following are merely exemplary and illustrative, and cannot limit the present disclosure.

### BRIEF DESCRIPTION OF DRAWINGS

FIG. 1 is a schematic structural diagram of a photovoltaic module according to one or more embodiments of the present disclosure.
FIG. 2 is a schematic diagram of a glue printing point position of a solar cell according to one or more embodiments of the present disclosure;
FIG. 3 is a schematic diagram of the glue printing point position of the solar cell according to one or more embodiments of the present disclosure;
FIG. 4 is a schematic partial structure diagram of a glue printing device according to one or more embodiments of the present disclosure;
FIG. 5 is a top view of a glue printing mesh of FIG. 4 according to one or more embodiments;
FIG. 6 is a sectional view of FIG. 5;
FIG. 7 is a top view of the glue printing mesh of FIG. 4 according to one or more embodiments;
FIG. 8 is a sectional view of FIG. 7;
FIG. 9 is a bottom view of an outer frame of FIG. 8 according to one or more embodiments;
FIG. 10 is a top view of the glue printing mesh of FIG. 4 according to one or more embodiments;
FIG. 11 is a sectional view of FIG. 10;
FIG. 12 is a sectional view of the glue printing mesh of FIG. 4 according to one or more embodiments;
FIG. 13 is a schematic diagram of comparison of surface structures of a magnetron sputtering hydrophobic coating in the present disclosure and a BM coating in the prior art;
FIG. 14 is a schematic partial structure diagram of a glue printing device according to one or more embodiments of the present disclosure; and
FIG. 15 is a top view of the glue printing mesh of FIG. 14 according to one or more embodiments.

### Reference signs:

100-first cover plate;
200-first adhesive film;
300-solar cell string;
400-second adhesive film;
500-second cover plate;
10- solar cell;
   101-finger;
20-solder strip;
30-solder point;
   301-first solder point;
   302-second solder point;
40-outer frame;
   401-first portion;
      401A-first surface;
   402-second portion;
      402A-second surface;
50-connection adhesive;
60-glue dot;
   601-first glue dot;
   602-second glue dot;
   603-third glue dot;
   604-fourth glue dot;
   605-fifth glue dot;
70-base;
80-glue printing mesh;
90-scraper;
   901-first scraper;
   902-second scraper;
1-mesh body;
   11-connection region;
      111-first region;
      112-second region;
   12-glue printing region;
      121-third surface;
      122-third region;
      123-fourth region;
   13-protruding rib;
      131-fourth surface;
2-mesh hole;
   21-first hole channel;
   22-second hole channel;
   23-third hole channel;
   24-fourth hole channel;
   25-unit row;
      251-first unit row;
      252-second unit row;
   26-fifth hole channel;
3-hydrophobic coating;
4-central axis.

The accompanying drawings herein, which are incorporated in and constitute a part of this specification, illustrate embodiments consistent with the present disclosure and, together with the specification, serve to explain principles of the present disclosure.

### DESCRIPTION OF EMBODIMENTS

In order to better illustrate the technical solutions of the present disclosure, the embodiments of the present disclosure will be described in detail below with reference to the accompanying drawings.

It should be clear that the described embodiments are only some of rather than all of the embodiments of the present disclosure. Based on the embodiments in the present disclosure, all other embodiments obtained by those of ordinary skill in the art without creative efforts shall fall within a scope of protection of the present disclosure.

The terms used in the embodiments of the present disclosure are only for the purpose of describing specific embodiments and are not intended to limit the present disclosure. As used in the embodiments of the present disclosure and the appended claims, the singular forms of "a/an", "one", and "the" are intended to include plural forms, unless otherwise clearly specified in the context.

It should be understood that the term "and/or" used herein is merely an association relationship describing associated objects, indicating that three relationships may exist. For example, A and/or B indicates that there are three cases: A alone, A and B together, and B alone. In addition, the character "/" herein generally indicates an "or" relationship between the associated objects.

It should be understood that, the terms such as "upper", "lower", "left", "right" and the like are used to indicate positions shown in the drawing, instead of being construed as limitations of the embodiment of the present disclosure. In addition, when an element is described as being "on" or "under" another element in the context, it should be understood that the element can be directly or via an intermediate element located "on" or "under" another element.

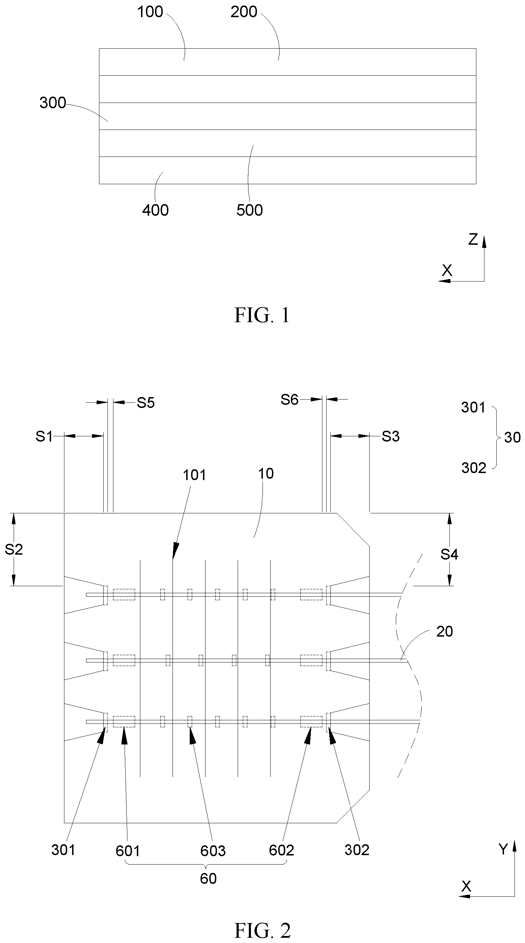

In a first aspect, embodiments of the present disclosure provide a photovoltaic module. The photovoltaic module is a core element for converting solar energy to be electric energy in the photovoltaic power generation technical field. As shown in FIG. 1, the photovoltaic module includes a first cover plate 100, a first adhesive film 200, a solar cell string 300, a second adhesive film 400 and a second cover plate 500 which are stacked in a thickness direction of the photovoltaic module. The first cover plate 100 and the solar cell string 300 are packaged and fixed by the first adhesive film 200, and the second cover plate 500 and the solar cell string 300 are packaged and fixed by the second adhesive film 400. Other layers may be provided between the first cover plate 100 and the first adhesive film 200, between the first adhesive film 200 and the solar cell string 300, between the solar cell string 300 and the second adhesive film 400, and between the second adhesive film 400 and the second cover plate 500, and a number of the layer(s) of the photovoltaic module is not particularly limited in the embodiments of the present disclosure.

One of a length direction and a width direction of the photovoltaic module is defined as a first direction X, while the other one of the length direction and the width direction of the photovoltaic module is defined as a second direction Y, and a thickness direction of the photovoltaic module is defined as a third direction Z. The solar cell string 300 includes a plurality of solar cells 10 arranged in the first direction X and the second direction Y, one of the first direction X and the second direction Y is a length direction of the solar cell 10, and the other one of the first direction X and the second direction Y is a width direction of the solar cell 10.

A type of the solar cell 10 is not particularly limited in the embodiments of the present disclosure, and the type of the solar cell 10 includes, but is not limited to, a passivated emitter rear cell (PERC), a tunnel oxide passivated contact (TOPCon) cell, a heterojunction with intrinsic thin-film (HJT) cell, an interdigitated back contact (IBC) cell, a perovskite cell, or the like.

In the thickness direction of the PERC, the PERC sequentially includes a front surface metal silver electrode, a front surface silicon nitride passivation layer, a phosphorus layer emitter, a P-type substrate silicon layer, a local aluminum back surface field, a metal aluminum back electrode and a back passivation layer (Al2O3/SiNx). In the PERC, a passivation film is used to passivate the back to replace an all-aluminum back field, which enhances internal back reflection of light on a silicon substrate, reduces a recombination rate on the back, and increases efficiency of the cell by 0.5% to 1%.

For the TOPCon cell, along a thickness direction thereof, the TOPCon cell sequentially includes a metal silver electrode, a front-surface silicon nitride passivation layer, a boron-doped emitter, an N-type substrate silicon layer, a diffusion doping layer, ultra-thin silicon oxide, doped polysilicon, silicon nitride, and a metal silver electrode. The back of the cell is formed by a layer of ultra-thin silicon oxide (1 nm to 2 nm) and a layer of phosphorus-doped microcrystalline amorphous mixed Si film, which jointly form a passivation contact structure. This structure can prevent recombinations of minority carriers and holes, and increase an open-circuit voltage and a short-circuit current of the cell. The ultra-thin oxide layer allows majority carriers and electrons to tunnel into a polysilicon layer and also prevents recombinations of minority carriers and holes. A good passivation effect of the ultra-thin silicon oxide and a heavily doped silicon film causes a surface energy band of a silicon wafer to bend, so as to form a field passivation effect, and a probability of electron tunneling is greatly increased, the contact resistance is decreased, and the open-circuit voltage and the short-circuit current of the cell is increased, thereby improving conversion efficiency of the cell.

For the HJT cell, along a thickness direction thereof, the HJT cell sequentially includes a front low-temperature silver electrode, a front conductive film, an N-type amorphous silicon film, an intrinsic amorphous silicon film, an N-type substrate silicon layer, an intrinsic amorphous silicon film, a P-type amorphous silicon film, a back conductive film, and a back low-temperature silver electrode.

For the IBC cell, along a thickness direction thereof, the IBC cell sequentially includes a silicon nitride anti-layer, an N+ front surface field, an N-type substrate silicon layer, a P+ emitter, an N+ back field, an aluminum oxide passivation layer, a silicon nitride antireflection layer, and a metal silver electrode. The IBC cell can obtain P regions and N regions with good uniformity and precise and controllable junction depths by using an ion implantation technology, and there is no electrode at the front of the solar cell, which can eliminate a blackout current loss of a metal electrode, realize maximum utilization of incident photons, and increase about 7% compared with the short-circuit current of a conventional solar cell. Due to a back contact structure, there is no need to consider the shielding of the electrode, and a proportion of the electrode can be appropriately widened, thereby reducing the series resistance and having a high fill factor. Surface passivation and a surface light trapping structure can be optimally designed, and a lower front surface recombination rate and surface reflection.

For the perovskite cell, along a thickness direction thereof, the perovskite cell sequentially includes a substrate material, a conductive film, an electron transport layer (titanium dioxide), a perovskite absorption layer (hole transport layer), and a metal cathode. A perovskite material has a high light absorption coefficient and a large carrier diffusion distance. After photons absorbed by the perovskite material are converted to be electrons, they are easily collected by the electrodes, and there is little loss. Therefore, high photogenerated voltages and currents can be generated, making perovskite exhibit a higher photoelectric conversion efficiency.

As shown in FIG. 2, the solar cell 10 includes fingers 101 extending along the second direction Y, and a plurality of fingers 101 are arranged at intervals along the first direction X. Solder strips 20 extending in the first direction X are fixed to the solar cell 10, and a plurality of solder strips are arranged at intervals along the second direction Y. The solder strip 20 is electrically connected to at least two fingers 101, and in the first direction X, the solder strip 20 is connected to at least two solar cells 10, to achieve series connection or parallel connection of adjacent solar cells 10. As shown in FIG. 2, the solar cell is provided with a solder point 30, the solar cell and the solder strip are soldered and fixed to each other at the solder point 30, the solar cell string 300 further includes a plurality of glue dots 60, and one part of at least one glue dot 60 is located at a surface of the solar cell 10 and another part of the at least one glue dot 60 is located at a surface of the solder strip 20, so that the solar cell 10 and the solder strip 20 are bonded and fixed to each other at the glue dot 60. The solder strip 20 is in direct contact with the finger 101, that is, the busbar structure in the prior art is canceled, so that the solar cell 10 is a busbar-free solar cell. During manufacturing of the solar cell 10, the busbar-free solar cell reduces an amount of silver paste, which helps to reduce a printing cost of the solar cell 10 and reduce a shielding area of the surface of the solar cell 10 by the electrode, thereby increasing an area of the solar cell 10 for contact with sunlight and thus helping to improve the photoelectric conversion efficiency of the solar cell 10.

During the manufacturing of the busbar-free solar cell, firstly, the surface of the solar cell 10 is coated with silver paste to form a plurality of fingers 101, and at least one solder point 30 is formed at the same time. Taking two solder points 30 as an example, as shown in FIG. 2, in the first direction X, the two solder points 30 are distributed on two sides of the solar cell 10 to pre-fix a same solder strip 20, and in the second direction Y, a plurality of solder points 30 are distributed at intervals to fix different solder strips 20, respectively. After the formation of the finger 101 and the solder points 30, a plurality of solar cells 10 and the solder strips 20 are soldered in series. Taking one solder strip 20 as an example, on one solar cell 10, the solder strip 20 is fixedly connected to two solder points 30 distributed along the first direction X, and the solder strip 20 is also soldered and fixed to the finger 101, so as to be pre-fixed to the solar cell 10. However, due to a small size of the finger 101, a connection force between the finger 101 and the solder strip 20 is weak, and there is a risk that the solder strip 20 and the finger 101 may be separated from each other during subsequent processing, transportation, mounting, or use. To this end, after the solder strip 20 and the solar cell 10 are pre-fixed, glue is applied to a side of the solder strip 20 facing away from the solar cell 10 at a preset glue dot 60 through the glue printing device, and after the glue is cured, the glue dot 60 is formed. One part of at least one glue dot 60 is located on the surface of the solder strip 20, and the other part of the of at least one glue dot 60 is located on the surface of the solar cell 10, so that the solder strip 20 is bonded and fixed to the surface of the solar cell 10. In addition, alternately, at least one glue dot 60 may be located only on the surface of the solder strip 20, and/or at least one glue dot 60 may be located only on the surface of the solar cell 10.

During the manufacturing, the solder strip and the solar cell are pre-fixed by soldering first, thereby reducing a risk of deviation of the solder strip during the printing, and thus improving accuracy of the position of the solder strip on the solar cell. Then, the solder strip and the solar cell are bonded and fixed by glue, thereby improving stability of the connection between the solder strip and the solar cell, and reducing the risk of separation of the solder strip from the solar cell during subsequent mounting, transportation, or use, and thus improving operational stability of the photovoltaic module and helping to prolong the service life of the photovoltaic module.

As shown in FIG. 2, on one solder strip 20, the glue dots 60 for applying the glue are arranged at intervals in the first direction X. That is, the glue is dot-applied in the first direction X, so that while bonding stability between the solder strip 20 and the solar cell 10 is satisfied, a glue amount can be reduced to reduce a glue printing cost.

As shown in FIG. 2, the solder points 30 include at least a first solder point 301 and a second solder point 302, along the first direction X, the first solder point 301 and the second solder point 302 are located on two sides of the solar cell 10, respectively. Part of the glue dots 60 may be located between the first solder point 301 and the second solder point 302, part of the glue dots 60 may be located at a side of the first solder point 301 facing away from the second solder point 302, and part of the glue dots 60 may be located at a side of the second solder point 302 facing away from the first solder point 301. For example, the glue dots 60 include a first glue dot 601, a second glue dot 602, and a plurality of third glue dots 603 distributed along the first direction X, and the plurality of third glue dots 603 are located between the first glue dot 601 and the second glue dot 602. The first glue dot 601 may be located at a side of the first solder point 301 facing away from the second solder point 302 and have a preset gap from the first solder point 301, or one part of the first glue dot 601 is located at a side of the first solder point 301 facing away from the second solder point 302 and another part of the first glue dot 601 is located above the first solder point 301 in the third direction Z, or one part of the first glue dot 601 is located at a side of the first solder point 301 facing away from the second solder point 302, one part of the first glue dot 601 is located above the first solder point 301 in the third direction Z and another part of the first glue dot 601 is located between the first solder point 301 and the second solder point 302, or one part of the first glue dot 601 is located above the first solder point 301 and another part of the first glue dot 601 is located between the first solder point 301 and the second solder point 302, or the first glue dot 601 is located at a side of the second solder point 302 facing away from the first solder point 301 and has a preset gap from the second solder point 302. Similarly, the second glue dot 602 may also have the above-mentioned five possible positions, which are not described in detail herein. Through the five possible positions of the first glue dot 601 and the second glue dot 602, flexibility of the positions of the first glue dot 601 and the second glue dot 602 can be improved.

For the convenience of description, it is assumed in the following that all the glue dots 60 are located between the first solder point 301 and the second solder point 302. That is, on one solder strip 20, two sides of the solder strip 20 in the first direction X are respectively pre-fixed to the solar cell 10 by the first solder point 301 and the second solder point 302. In the first direction X, the glue dot(s) 60 is arranged between the first solder point 301 and the second solder point 302, to reduce a risk of bending and movement of the solder strip 20 during the glue printing of the solar cell 10.

The first solder points 301 on adjacent solder strips 20 are directly opposite to each other in the second direction Y; and the second solder points 302 on the adjacent solder strips 20 are directly opposite to each other in the second direction Y. During soldering and pre-fixing of the solder strip 20 and the solar cell 10, all the solder strips 20 on one solar cell 10 can be simultaneously pre-fixed to the solar cell 10 at the first solder point 301 and/or the second solder point 302, thereby reducing a risk of deviation of the solder strip 20 during the soldering.

As shown in FIG. 2, along the first direction X, a distance S1 between the first solder point 301 and an edge of the solar cell 10 satisfies 7 mm≤S1≤8 mm, which may be, for example, 7 mm, 7.1 mm, 7.2 mm, 7.3 mm, 7.4 mm, 7.5 mm, 7.6 mm, 7.7 mm, 7.8 mm, 7.9 mm, 8 mm, or the like; along the second direction Y, a distance S2 between the first solder point 301 and an edge of the solar cell 10 satisfies 7 mm≤S2≤8 mm, which may be, for example, 7 mm, 7.1 mm, 7.2 mm, 7.3 mm, 7.4 mm, 7.5 mm, 7.6 mm, 7.7 mm, 7.8 mm, 7.9 mm, 8 mm, or the like; and/or along the first direction X, a distance S3 between the second solder point 302 and an edge of the solar cell 10 satisfies 7 mm≤S3≤8 mm, which may be, for example, 7 mm, 7.1 mm, 7.2 mm, 7.3 mm, 7.4 mm, 7.5 mm, 7.6 mm, 7.7 mm, 7.8 mm, 7.9 mm, 8 mm, or the like; and along the second direction Y, a distance S4 between the second solder point 302 and an edge of the solar cell 10 satisfies 7 mm≤S4≤8 mm, which may be, for example, 7 mm, 7.1 mm, 7.2 mm, 7.3 mm, 7.4 mm, 7.5 mm, 7.6 mm, 7.7 mm, 7.8 mm, 7.9 mm, 8 mm, or the like.

If the distance between the solder point 30 and the edge of the solar cell 10 is less than 7 mm, difficulty of soldering of the solder strip 20 and the solar cell 10 is increased, and precision for soldering of the solder strip 20 and the solar cell 10 is also increased. If the distance between the solder point 30 and the edge of the solar cell 10 is larger than 8 mm, a distance between the first solder point 301 and the second solder point 302 in the first direction X is reduced, thereby reducing a region for arranging the glue dot 60 and affecting a number of the glue dots 60 that can be arranged. Therefore, when the distance between the solder point 30 and the edge of the solar cell 10 ranges from 7 mm to 8 mm, difficulty of and precision for soldering of the solder strip 20 and the solar cell 10 can be reduced, thereby reducing a soldering cost of the solder strip 20 and the solar cell 10 and also increasing the distance between the first solder point 301 and the second solder point 302 in the first direction X, so as to increase the number of the glue dots 60 that can be arranged.

As shown in FIG. 2, the solder strips 20 include at least a first solder strip 20 and a second solder strip 20 arranged along the second direction Y, at least part of the glue dots 60 on the first solder strip 20 are not aligned with at least part of the glue dots 60 on the second solder strip 20 in the second direction Y, so that when relative positions of the glue printing device and the solar cell 10 in the first direction X deviate from each other, the glue printing positions on the solder strips 20 deviate from preset positions of glue dots 60, due to the misalignment of the glue dots 60, on one finger 101, one part of glue printing positions are farther away from positions where the solder strips 20 are in contact with the finger 101, and another part of glue printing positions are closer to positions where the solder strips 20 are in contact with the finger 101, thereby reducing a risk that all glue printing positions are away from the positions where the solder strips 20 are in contact with the finger 101, and reducing a risk of failure of all electrical connections between the finger 101 and all the solder strips 20, so as to improve operational stability of the solar cell 10 and the photovoltaic module.

As shown in FIG. 2, the first glue dot 601 on the first solder strip 20 is directly opposite to the first glue dot 601 on the second solder strip 20 in the second direction Y, and/or the second glue dot 602 on the first solder strip 20 is directly opposite to the second glue dot 602 on the second solder strip 20 in the second direction Y; and the third glue dots 603 on the first solder strip 20 are not aligned with the third glue dots 603 on the second solder strip 20 in the second direction Y.

The glue printing device includes a base configured to support the solar cell 10, a glue printing mesh configured to be pressed on the surface of the solar cell 10, and a scraper. The scraper is configured to press down the glue printing mesh and scrape the glue into the mesh holes formed in the glue printing mesh, so that the glue flows along the mesh holes onto the surfaces of the solar cell 10 and the solder strip 20. The first glue dots 601 on adjacent solder strips 20 are aligned with each other and the second glue dots 602 on the adjacent solder strips 20 are aligned with each other, which helps to improve consistency of forces of the scraper in the second direction Y at an initial position where the scraper presses down the glue printing mesh, thereby helping to reduce difficulty of debugging of a downward pressing force of the scraper.

As shown in FIG. 2, along the first direction X, a plurality of third glue dots 603 are evenly distributed between the first glue dot 601 and the second glue dot 602. If the third glue dots 603 are unevenly distributed, a distance between two adjacent third glue dots 603 is smaller while a distance between another two adjacent third glue dots 603 is larger, in this case, a risk of failure of contact between the solder strip 20 and the finger 101 is higher between the two adjacent third glue dots 603 with the larger distance. Therefore, the even distribution of the third glue dots 603 between the first glue dot 601 and the second glue dot 602 can further reduce the risk of failure of contact between the solder strip 20 and the finger 101, thereby improving operational stability of the solar cell 10 and the photovoltaic module.

A number N1 of the third glue dots 603 in the first direction X satisfies 4≤N1≤21. The number of the third glue dots 603 may be 4, 5, 6, 7, 8, 9, 10, 11, 12, 13, 14, 15, 16, 17, 18, 19, 20, 21, or the like. If the number of the third glue dots 603 on the first solder strip 20 is less than 4, the number of the third glue dots 603 on the second solder strip 20 adjacent thereto may be less, which reduces reliability of bonding between the solder strip 20 and the solar cell 10. If the number of the third glue dots 603 distributed in the first direction X is too many, a glue printing cost of the solar cell 10 is increased. Therefore, when 4≤N1≤21, the glue printing cost of the solar cell 10 can be reduce while the reliability of bonding between the solder strip 20 and the solar cell 10 can be improved.

In a possible design, as shown in FIG. 2, a length of the first glue dot 601 in the first direction X ranges from 6 mm to 9 mm, which may be, for example, 6 mm, 6.1 mm, 6.3 mm, 6.5 mm, 6.7 mm, 6.9 mm, 7 mm, 7.1 mm, 7.3 mm, 7.5 mm, 7.7 mm, 7.9 mm, 8 mm, 8.1 mm, 8.3 mm, 8.5 mm, 8.7 mm, 8.9 mm, 9 mm, or the like, and/or a length of the second glue dot 602 in the first direction X ranges from 6 mm to 9 mm, which may be, for example, 6 mm, 6.1 mm, 6.3 mm, 6.5 mm, 6.7 mm, 6.9 mm, 7 mm, 7.1 mm, 7.3 mm, 7.5 mm, 7.7 mm, 7.9 mm, 8 mm, 8.1 mm, 8.3 mm, 8.5 mm, 8.7 mm, 8.9 mm, 9 mm, or the like.

When the length of the first glue dot 601 in the first direction X ranges from 6 mm to 9 mm and the length of the second glue dot 602 in the first direction X ranges from 6 mm to 9 mm, difficulty of glue output of the glue printing device at the first glue dot 601 and the second glue dot 602 can be reduced, and an amount of glue at the first glue dot 601 and the second glue dot 602 can be increased, thereby improving stability of bonding between the solder strip 20 and the solar cell 10 at the first glue dot 601 and the second glue dot 602.

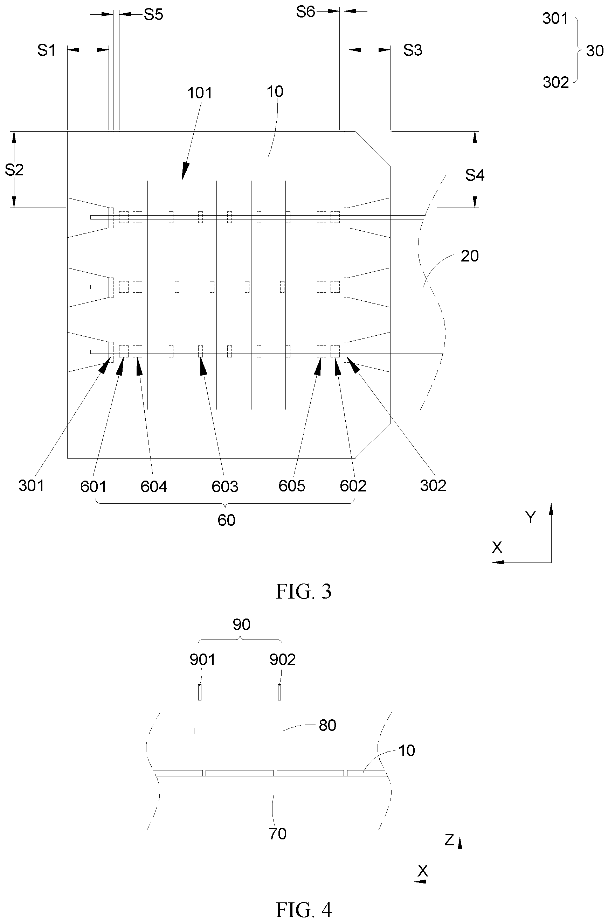

In another possible design, as shown in FIG. 3, the glue dots 60 further include a fourth glue dot 604, and along the first direction X, the fourth glue dot 604 is located between the first glue dot 601 and the second glue dot 602, and the third glue dot 603 is located between the fourth glue dot 604 and the second glue dot 602. A length of the first glue dot 601 in the first direction X ranges from 0.2 mm to 0.4 mm, the length of the first glue dot 601 in the first direction X may be 0.2 mm, 0.21 mm, 0.23 mm, 0.25 mm, 0.27 mm, 0.29 mm, 0.3 mm, 0.31 mm, 0.33 mm, 0.35 mm, 0.37 mm, 0.39 mm, 0.4 mm, or the like; a length of the fourth glue dot 604 in the first direction X ranges from 0.2 mm to 0.4 mm, the length of the fourth glue dot 604 in the first direction X may be 0.2 mm, 0.21 mm, 0.23 mm, 0.25 mm, 0.27 mm, 0.29 mm, 0.3 mm, 0.31 mm, 0.33 mm, 0.35 mm, 0.37 mm, 0.39 mm, 0.4 mm, or the like; and a distance between the first glue dot 601 and the fourth glue dot 604 in the first direction X ranges from 6 mm to 9 mm. And/or, the glue dots 60 further include a fifth glue dot 605, and along the first direction X, the fifth glue dot 605 is located between the first glue dot 601 and the second glue dot 602, and the third glue dot 603 is located between the first glue dot 601 and the fifth glue dot 605. A length of the second glue dot 602 in the first direction X ranges from 0.2 mm to 0.4 mm, the length of the second glue dot 602 in the first direction X may be 0.2 mm, 0.21 mm, 0.23 mm, 0.25 mm, 0.27 mm, 0.29 mm, 0.3 mm, 0.31 mm, 0.33 mm, 0.35 mm, 0.37 mm, 0.39 mm, 0.4 mm, or the like; a length of the fifth glue dot 605 in the first direction X ranges from 0.2 mm to 0.4 mm, the length in the first direction X may be 0.2 mm, 0.21 mm, 0.23 mm, 0.25 mm, 0.27 mm, 0.29 mm, 0.3 mm, 0.31 mm, 0.33 mm, 0.35 mm, 0.37 mm, 0.39 mm, 0.4 mm, or the like; and a distance between the second glue dot 602 and the fifth glue dot 605 in the first direction X ranges from 6 mm to 9 mm. That is, one longer glue dot 60 of 6 mm to 9 mm in the previous design is changed to be two shorter glue dots 60 of 0.2 mm to 0.4 mm, which can reduce the amount of glue without changing the stability of bonding between the solder strip 20 and the solar cell 10, thereby reducing the glue printing cost of the solar cell 10.

As shown in FIG. 2 and FIG. 3, along the first direction X, a distance S5 between the first glue dot 601 and the first solder point 301 satisfies 1 mm≤S5≤2 mm, which may be, for example, 1 mm, 1.1 mm, 1.2 mm, 1.3 mm, 1.4 mm, 1.5 mm, 1.6 mm, 1.7 mm, 1.8 mm, 1.9 mm, 2 mm, or the like; and/or along the first direction X, a distance S6 between the second glue dot 602 and the second solder point 302 satisfies 1 mm≤S6≤2 mm, which may be, for example, 1 mm, 1.1 mm, 1.2 mm, 1.3 mm, 1.4 mm, 1.5 mm, 1.6 mm, 1.7 mm, 1.8 mm, 1.9 mm, 2 mm, or the like.

If the distances from the first glue dot 601 and the second glue dot 602 to the solder point 30 are smaller, there is a risk of local thickening of the solar cell 10 caused by part of the first glue dot 601 and the second glue dot 602 being located above the solder point 30, thereby increasing a risk of damage to the solar cell 10 at the first glue dot 601, the second glue dot 602, and the solder point 30. If the distances from the first glue dot 601 and the second glue dot 602 to the solder point 30 are larger, a region between the first glue dot 601 and the second glue dot 602 used to arrange the third glue dot 603 is reduced, which affects the number of the third glue dot(s) 603 that can be arranged. Therefore, when the distance from the first glue dot 601 to the solder point 30 and the distance from the second glue dot 602 to the solder point 30 each range from 1 mm to 2 mm, a risk of damage to the solar cell 10 at the first glue dot 601, the second glue dot 602, and the solder point 30 is reduced, and it is conducive to increasing the number of the third glue dot(s) 603 that can be arranged.

In any one of the embodiments described above, a length of the third solder point 30 in the first direction X ranges from 5 mm to 20 mm, which may be, for example, 5 mm, 6 mm, 7 mm, 8 mm, 9 mm, 10 mm, 11 mm, 12 mm, 13 mm, 14 mm, 15 mm, 16 mm, 17 mm, 18 mm, 19 mm, 20 mm, or the like.

In any one of the embodiments described above, a number N2 of the solder strips 20 in the second direction Y satisfies 14≤N2≤16, and the first solder strip 20 and the second solder strip 20 are alternately arranged at intervals in the second direction Y. The number of the solder strips 20 may be 14, 15, or 16. If more solder strips 20 are arranged, a distance between adjacent solder strips 20 is smaller, then there is a risk of short circuit of the solar cell 10 caused by contact between adjacent solder strips 20, and more solder strips 20 also increase shielding of the surface of the solar cell 10, thereby affecting conversion efficiency of the solar cell 10. If less solder strips 20 are arranged, the solder strips 20 have low current transfer efficiency, resulting in low output power of the photovoltaic module. Therefore, when the number of the solder strips 20 ranges from 14 to 16, a risk of short circuit of the solar cell 10 caused by contact between adjacent solder strips 20 is reduced, operational stability of the solar cell 10 is improved, and it is conducive to increasing a light-receiving area of the solar cell 10, thereby helping to improve photoelectric conversion efficiency of the solar cell 10. In addition, current transfer efficiency of the solder strip 20 is improved, thereby increasing output power of the photovoltaic module.

The first solder strips 20 are symmetrically distributed about an axis extending along the first direction X on the solar cell 10, and the second solder strips 20 are symmetrically distributed about the axis extending along the first direction X on the solar cell 10, so that when the scraper presses down during glue printing of the solar cell 10 by the glue printing device, a glue printing mesh body is evenly stressed on two sides of the second direction Y.

In addition, two surfaces of the solar cell 10 opposite to each other along the third direction Z need to be bonded and fixed to the solder strips 20, respectively. For example, a light-facing surface of the solar cell 10 is provided with the first solder strip 20 and the second solder strip 20 adjacent to each other, and a backlight surface is provided with a third solder strip 20 and a fourth solder strip 20 adjacent to each other. In the third direction Z, the first solder strip 20 is located above the third solder strip 20, and the second solder strip 20 is located above the fourth solder strip 20, in this case, the third glue dots 603 on the first solder strip 20 and the third glue dots 603 on the third solder strip 20 are not aligned in the second direction Y, and the third glue dots 603 on the second solder strip 20 and the third glue dots 603 on the fourth solder strip 20 are not aligned in the second direction Y.

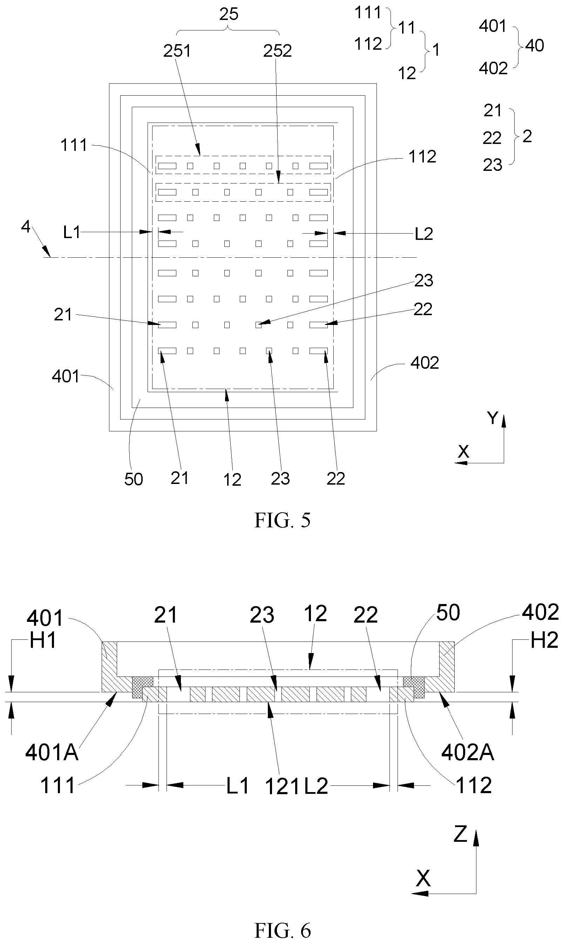

Based on the photovoltaic module in any one of the embodiments described above, in a second aspect, some embodiments of the present disclosure provide a glue printing device. As shown in FIG. 4, the glue printing device includes a base 70, a glue printing mesh 80, and a scraper 90. The base 70 is configured to support the solar cell 10. The solar cell 10 and the glue printing mesh 80 are arranged along the third direction Z. As shown in FIG. 5, the glue printing mesh 80 includes a mesh body 1 and an outer frame 40 arranged on the mesh body 1. The outer frame 40 is fixedly connected to the base 70. Along a thickness direction of the glue printing mesh 80, i.e., along the third direction Z, a scraper 90 is arranged at a side of the glue printing mesh 80 facing away from the solar cell 10. The scraper 90 is configured to press down the mesh body 1 along the thickness direction Z of the glue printing mesh 80 and configured to scrape the glue of the glue printing mesh 80 into the mesh holes 2. The mesh holes 2 are in one-to-one correspondence to the glue dots 60 on the solar cell 10. As shown in FIG. 4, the scraper 90 includes a first scraper 901 and a second scraper 902 arranged along the first direction X. The first scraper 901 and the second scraper 902 operate alternately.

As shown in FIG. 4, a plurality of solar cells 10 and solder strips 20 are pre-soldered through the solder points 30 and then placed on the base 70. In this case, a plurality of solar cells 10 are distributed at intervals along the first direction X, and in the third direction Z, the glue printing mesh 80 is located directly above the first solar cell 10. Afterwards, the glue printing mesh 80 is driven to move along the third direction Z towards the solar cell 10 until the glue printing mesh 80 abuts against the solar cell 10, and then the first scraper 901 is driven to move along the third direction Z towards the glue printing mesh 80. The first scraper 901 abuts against the mesh body 1 and presses down the mesh body 1, so that interaction forces along the third direction Z exist between the first scraper 901 and the mesh body 1 and between the mesh body 1 and the solar cell 10. Afterwards, the first scraper 901 moves along the first direction X. A movement direction of the first scraper 901 may be either a positive direction of the first direction X, i.e., a direction pointed by the arrow of the first direction X shown in FIG. 4, or a negative direction of the first direction X, i.e., a direction opposite to the direction pointed by the arrow of the first direction X shown in FIG. 4. For example, the first scraper 901 moves along the negative direction of the first direction X, a side of the mesh body 1 facing away from the solar cell 10 is provided with glue, and with the movement of the first scraper 901, the glue is pushed to the mesh holes 2 formed in the mesh body 1 and then flows through the mesh holes 2 to reach the surfaces of the solder strip 20 and the first solar cell 10. After completing a scraping stroke, the first scraper 901 may move along the third direction Z and towards a direction facing away from the glue printing mesh 80 and the glue printing mesh 80 may move along the third direction Z and towards a direction facing away from the solar cell 10, so that the glue printing mesh 80 is separated from the solar cell 10 and the first scraper 901 is separated from the glue printing mesh 80. At the same time, the base 70 drives the solar cell 10 to move along the first direction X, so that the first solar cell 10 that has been coated with the glue moves to a curing station to facilitate curing of the glue. When the second solar cell 10 is directly opposite to the glue printing mesh 80 in the third direction Z, the glue printing mesh 80 is pressed down again, and the second scraper 902 presses down and moves along the positive direction of the first direction X, so that glue flows through the mesh holes 2 to reach the surfaces of the solder strip 20 and the second solar cell 10. The glue printing device performs cyclic reciprocating motion according to the above-described processes, to realize a glue printing operation on the third solar cell 10, the fourth solar cell 10, and other more solar cells 10.

Through the arrangement of the first scraper 901 and the second scraper 902, the waiting time between two glue printing operations of the glue printing device is reduced, thereby improving the glue printing efficiency of the glue printing device.

As shown in FIG. 5 and FIG. 6, the glue printing mesh 80 includes an outer frame 40, a mesh body 1, and mesh holes 2. The mesh body 1 includes a connection region 11 and a glue printing region 12. The glue is applied to a surface at a side of the glue printing region 12 facing away from the solar cell 10. The connection region 11 surrounds an outer side of the glue printing region 12. The outer frame 40 is arranged at an edge of the connection region 11, and the outer frame 40 is bonded and fixed to the edge of the connection region 11 through a connection adhesive 50. In the first direction X and the second direction Y, part of the connection adhesive 50 is located between the outer frame 40 and the edge of the connection region 11; and in the third direction Z, part of the connection adhesive 50 overflows onto the surface at a side of the connection region 11 facing away from the solar cell 10. A plurality of mesh holes 2 are arranged along the first direction X to form a unit row 25. A plurality of unit rows 25 are arranged along the second direction Y. Four or more mesh holes 2 are provided in one unit row 25, so as to improve bonding strength of the solder strip 20 and the solar cell 10, and improve bonding stability of the solder strip 20 and the solar cell 10.

Adjacent unit rows 25 are respectively defined as a first unit row 251 and a second unit row 252. For example, the first unit row 251 is located above the first solder strip, and the second unit row 252 is located above the second solder strip.

In a possible design, the mesh holes 2 in the first unit row 251 is directly opposite to the mesh holes 2 in the second unit row 252 one by one in the second direction Y. For example, each of the first unit row 251 and the second unit row 252 includes a first hole channel 21, a fourth hole channel 24, a third hole channel 23, a fifth hole channel 26 and a second hole channel 22 sequentially arranged in the first direction X, in this case, the first hole channel 21 in the first unit row 251 is directly opposite to the first hole channel 21 in the second unit row 252, the fourth hole channel 24 in the first unit row 251 is directly opposite to the fourth hole channel 24 in the second unit row 252, the third hole channel 23 in the first unit row 251 is directly opposite to the third hole channel 23 in the second unit row 252, the fifth hole channel 26 in the first unit row 251 is directly opposite to the fifth hole channel 26 in the second unit row 252, and the second hole channel 22 in the first unit row 251 is directly opposite to the second hole channel 22 in the second unit row 252.

In another possible design, some of the mesh holes 2 in the first unit row 251 are not aligned with some of the mesh holes 2 in the second unit row 252 in the second direction Y. For example, the first hole channel 21 in the first unit row 251 is directly opposite to the first hole channel 21 in the second unit row 252, the second hole channel 22 in the first unit row 251 is directly opposite to the second hole channel 22 in the second unit row 252, but the fourth hole channel 24 in the first unit row 251 and the fourth hole channel 24 in the second unit row 252 have a distance larger than 0 in the first direction X, the third hole channel 23 in the first unit row 251 and the third hole channel 23 in the second unit row 252 have a distance larger than 0 in the first direction X, and the fifth hole channel 26 in the first unit row 251 and the fifth hole channel 26 in the second unit row 252 have a distance larger than 0 in the first direction X. When the mesh holes 2 between the first hole channel 21 and the second hole channel 22 are evenly distributed in one unit row 25, and the mesh holes 2 between the first hole channel 21 and the second hole channel 22 are not aligned in the adjacent unit row 25, the number of the mesh holes 2 in the first unit row 251 is different from the number of the mesh holes 2 in the second unit row 252. For example, the number of the mesh holes 2 in the first unit row 251 is five, and the number of the mesh holes 2 in the second unit row 252 may be four, so as to reduce the number of the mesh holes 2 to further reduce the glue printing cost of the solar cell 10.

Some of the mesh holes 2 in the first unit row 251 are not aligned with some of the mesh holes 2 in the second unit row 252 in the second direction Y. When relative positions of the glue printing mesh 80 and the solar cell 10 in the first direction X deviate from each other, the glue printing positions on the solder strips 20 deviate from preset positions of glue dots 60, due to the misalignment of the glue dots 60, on one finger 101, one part of glue printing positions are farther away from positions where the solder strips 20 are in contact with the finger 101, and another part of glue printing positions are closer to positions where the solder strips 20 are in contact with the finger 101, thereby reducing a risk that all glue printing positions are away from the positions where the solder strips 20 are in contact with the finger 101, and reducing a risk of failure of all electrical connections between the finger 101 and all the solder strips 20, so as to improve operational stability of the solar cell 10 and the photovoltaic module.

For example, as shown in FIG. 5, the mesh holes 2 at least include a first hole channel 21, a second hole channel 22 and third hole channels 23. The first hole channel 21 corresponds to a first glue dot 601 on the solar cell 10, the second hole channel 22 corresponds to a second glue dot 602 on the solar cell 10, and the third hole channels 23 correspond to third glue dots 603 on the solar cell 10. In the same distribution form as the first glue dot 601, the second glue dot 602 and the third glue dots 603, along the first direction X, the first hole channel 21 is located on a side of the glue printing region 12 close to a first portion 401, the second hole channel 22 is located on a side of the glue printing region 12 close to a second portion 402, and the third hole channels 23 are arranged at intervals and located between the first hole channel 21 and the second hole channel 22. The first hole channel 21 in the first unit row 251 is aligned with the first hole channel 21 in the second unit row 252 in the second direction Y, the second hole channel 22 in the first unit row 251 is aligned with the second hole channel 22 in the second unit row 252 in the second direction Y, and the third hole channel 23 in the first unit row 251 is not aligned with the third hole channel 23 in the second unit row 252 in the second direction Y.

Furthermore, two surfaces of the solar cell 10 opposite to each other along the third direction Z are required to be bonded and fixed to the solder strip 20, respectively. For example, a light-facing surface of the solar cell 10 is provided with the first unit row 251 and the second unit row 252 adjacent to each other, and a backlight surface of the solar cell 10 is provided with a third unit row and a fourth unit row adjacent to each other. In the third direction Z, the first unit row 251 is located above the third unit row, and the second unit row 252 is located above the fourth unit row, in this case, part of the mesh holes 2 in the first unit row 251 and part of the mesh holes 2 in the third unit row are not aligned in the second direction Y, and part of the mesh holes 2 in the second unit row 252 and part of the mesh holes 2 in the fourth unit row are not aligned in the second direction Y.

A number of the third hole channels 23 arranged in the first unit row 251 ranges from 4 to 21, and/or a number of the third hole channels 23 arranged in the second unit row 252 ranges from 4 to 21.

As shown in FIG. 5, the glue printing mesh 80 has a central axis 4 extending along the first direction X, and a plurality of unit rows 25 are symmetrically distributed about the central axis 4, so that two sides of the mesh body 1 in the second direction Y are evenly stressed during downward pressing of the scraper 90.

As shown in FIG. 5, the outer frame 40 includes a first portion 401 and a second portion 402, and the first portion 401 and the second portion 402 are located at two sides of the mesh body 1 in the first direction X. The connection region 11 includes a first region 111 and a second region 112, the first region 111 is fixedly bonded to the first portion 401, and the second region 112 is fixedly bonded to the second portion 402. In the first direction X, the first hole channel 21 is located on a side of the glue printing region 12 close to the first portion 401, the second hole channel 22 is located on a side of the glue printing region 12 close to the second portion 402, the third hole channels 23 are arranged at intervals and located between the first hole channel 21 and the second hole channel 22.

In a possible design, as shown in FIG. 5, a length of the first hole channel 21 in the first direction X ranges from 6 mm to 9 mm, for example, 6 mm, 6.1 mm, 6.3 mm, 6.5 mm, 6.7 mm, 6.9 mm, 7 mm, 7.1 mm, 7.3 mm, 7.5 mm, 7.7 mm, 7.9 mm, 8 mm, 8.1 mm, 8.3 mm, 8.5 mm, 8.7 mm, 8.9 mm, 9 mm, or the like, and/or a length of the second hole channel 22 in the first direction X ranges from 6 mm to 9 mm, for example, 6 mm, 6.1 mm, 6.3 mm, 6.5 mm, 6.7 mm, 6.9 mm, 7 mm, 7.1 mm, 7.3 mm, 7.5 mm, 7.7 mm, 7.9 mm, 8 mm, 8.1 mm, 8.3 mm, 8.5 mm, 8.9 mm, 9 mm, or the like.

The length of the first hole channel 21 in the first direction X ranges from 6 mm to 9 mm, and the length of the second hole channel 22 in the first direction X ranges from 6 mm to 9 mm, difficulty of glue output at the first hole channel 21 and the second hole channel 22 can be reduced, and an amount of glue at the first hole channel 21 and the second hole channel 22 can be increased, thereby improving stability of bonding between the solder strip 20 and the solar cell 10 at the first hole channel 21 and the second hole channel 22.

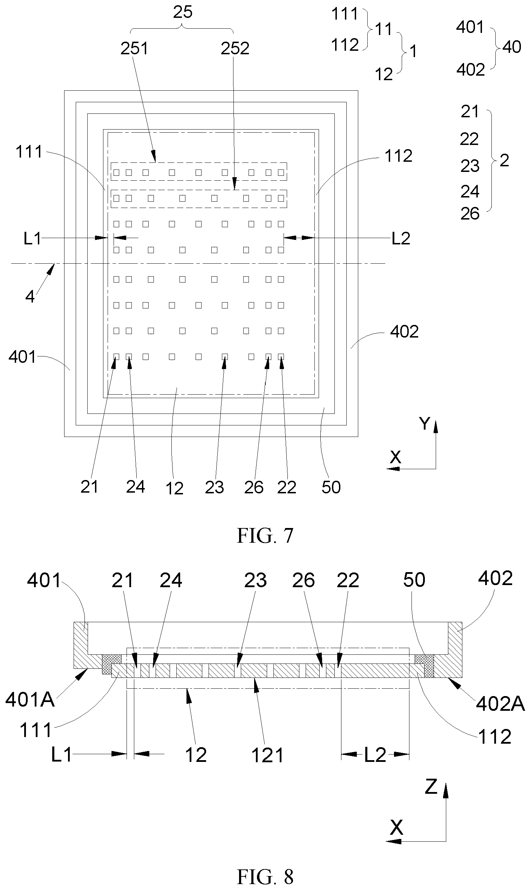

In another possible design, as shown in FIG. 7, the mesh holes 2 further include a fourth hole channel 24. In the first direction X, the fourth hole channel 24 is located on a side of the glue printing region 12 close to the first portion 401, the fourth hole channel 24 is located between the first hole channel 21 and the second hole channel 22, and the third hole channels 23 are located between the fourth hole channel 24 and the second hole channel 22. A length of the first hole channel 21 in the first direction X ranges from 0.2 mm to 0.4 mm, for example, 0.2 mm, 0.21 mm, 0.23 mm, 0.25 mm, 0.27 mm, 0.29 mm, 0.3 mm, 0.31 mm, 0.33 mm, 0.35 mm, 0.37 mm, 0.39 mm, 0.4 mm, or the like; and a length of the fourth hole channel 24 in the first direction X ranges from 0.2 mm to 0.4 mm, for example, 0.2 mm, 0.21 mm, 0.23 mm, 0.25 mm, 0.27 mm, 0.29 mm, 0.3 mm, 0.31 mm, 0.33 mm, 0.35 mm, 0.37 mm, 0.39 mm, 0.4 mm, or the like. And/or, the mesh holes 2 further include a fifth hole channel 26. In the first direction X, the fifth hole channel 26 is located on a side of the glue printing region 12 close to the second portion 402, the fifth hole channel 26 is located between the first hole channel 21 and the second hole channel 22, and the third hole channels 23 are located between the fifth hole channel 26 and the first hole channel 21. A length of the second hole channel 22 in the first direction X ranges from 0.2 mm to 0.4 mm, for example, 0.2 mm, 0.21 mm, 0.23 mm, 0.25 mm, 0.27 mm, 0.29 mm, 0.3 mm, 0.31 mm, 0.33 mm, 0.35 mm, 0.37 mm, 0.39 mm, 0.4 mm, or the like; and a length of the fifth hole channel 26 in the first direction X ranges from 0.2 mm to 0.4 mm, for example, 0.2 mm, 0.21 mm, 0.23 mm, 0.25 mm, 0.27 mm, 0.29 mm, 0.3 mm, 0.31 mm, 0.33 mm, 0.35 mm, 0.37 mm, 0.39 mm, 0.4 mm, or the like.

The length of the first hole channel 21 ranges from 0.2 mm to 0.4 mm, the length of the fourth hole channel 24 ranges from 0.2 mm to 0.4 mm, the length of the second hole channel 22 ranges from 0.2 mm to 0.4 mm, and the length of the fifth hole channel 26 ranges from 0.2 mm to 0.4 mm. That is, one longer hole channel of 6 mm-9 mm is changed to be two shorter hole channels of 0.2 mm-0.4 mm, which can reduce the amount of glue output at the edge without changing the stability of bonding between the solder strip 20 and the solar cell 10, thereby reducing the glue printing cost of the solar cell 10.

A dimension of the third hole channel 23 in the first direction X ranges from 5 mm to 20 mm, for example, 5 mm, 6 mm, 7 mm, 8 mm, 9 mm, 10 mm, 11 mm, 12 mm, 13 mm, 14 mm, 15 mm, 16 mm, 17 mm, 18 mm, 19 mm, 20 mm, or the like.

In any one of the embodiments described above, a width of the mesh hole 2 in the second direction Y ranges from 1 mm to 1.4 mm, for example, 1 mm, 1.01 mm, 1.03 mm, 1.05 mm, 1.07 mm, 1.09 mm, 1.1 mm, 1.11 mm, 1.13 mm, 1.15 mm, 1.17 mm, 1.19 mm, 1.2 mm, 1.21 mm, 1.23 mm, 1.25 mm, 1.27 mm, 1.29 mm, 1.3 mm, 1.31 mm, 1.33 mm, 1.35 mm, 1.37 mm, 1.39 mm, 1.4 mm, or the like.

During the glue printing of the solar cell 10 by the glue printing device, since the distance between two adjacent solar cells 10 in the first direction X is smaller, taking the second solar cell 10 as an example, when the glue printing device performs a glue printing operation on the second solar cell 10, there is a risk of abutment of the glue printing mesh 80 against the first solar cell 10, thereby leading to a risk of reduction in the amount of glue caused by adhesion of uncured glue on the first cell 10 to the glue printing mesh 80, that is, a risk of glue smearing of the glue printing mesh 80. At the same time, during the subsequent glue printing, there is also a risk of damage to the solar cell 10 caused by abutment of the glue adhered to the glue printing mesh 80 against the solar cell 10.

To this end, a protruding portion may be provided on the mesh body 1. The protruding portion is arranged at a side of the glue printing region 12 in the third direction Z, a side of the protruding portion facing away from the mesh body 1 is configured to abut against the solar cell 10, the mesh holes 2 are formed in the glue printing region 12, and the mesh holes 2 pass through the mesh body 1 along the third direction Z.

Due to the arrangement of the protruding portion and a certain height difference between the protruding portion and a frame, a surface of a side of the glue printing mesh 80 close to the solar cell 10 has a step surface, and when the protruding portion abuts against one solar cell 10 in the third direction Z, a certain gap exists between the glue printing mesh 80 and an adjacent solar cell 10 in the third direction Z, so that a risk that the glue printing mesh 80 abuts against the adjacent solar cell 10 is reduced, and a risk that the uncured glue on the adjacent solar cell 10 adheres to a surface of the glue printing mesh 80 is reduced, that is, a risk of glue rubbing of the glue printing mesh 80 is reduced, thereby improving consistency of an actual glue printing amount and a theoretical glue printing amount of the adjacent solar cell 10; meanwhile, a risk that the glue is cured on a surface of a side of the glue printing mesh 80 close to the solar cell 10 is reduced, thereby reducing a risk that the cured glue on the glue printing mesh 80 abuts against the adjacent solar cell 10 to damage the adjacent solar cell 10, thus improving a processing yield of the solar cell 10 and improving a yield and production capacity of the photovoltaic module.

The protruding portion has two structural forms. In a possible design, as shown in FIG. 6, the mesh body 1 sinks to be bonded on the outer frame 40. That is, along the third direction Z, a bonding position of the mesh body 1 on the outer frame 40 is lower, so that a part of the glue printing region 12 protrudes from the outer frame 40 to form the protruding portion. This structural form simplifies the structure of the mesh body 1, thereby facilitating a reduction of a processing cost and processing difficulty of the mesh body 1.

As shown in FIG. 6, the outer frame 40 includes a first portion 401 and a second portion 402, the first portion 401 and the second portion 402 are located on two sides of the mesh body 1 in the first direction X, the connection region 11 includes a first region 111 and a second region 112, the first region 111 is bonded to the first portion 401, and the second region 112 is bonded to the second portion 402. For example, the glue printing region 12 is directly opposite to the second solar cell 10 in the third direction Z, in this case, the first portion 401 is located on a side close to the first solar cell and a part of the first portion 401 is directly opposite to a part of the first solar cell in the third direction Z, and the second portion 402 is located on a side close to the second solar cell and a part of the second portion 402 is directly opposite to a part of the second solar cell in the third direction Z.

As shown in FIG. 6, the first portion 401 is provided with a first surface 401A, the second portion 402 is provided with a second surface 402A, the glue printing region 12 is provided with a third surface 121; and the first surface 401A, the second surface 402A and the third surface 121 are all located on a side of the glue printing mesh 80 facing the solar cell 10 in the third direction Z. A height difference H1 between the third surface 121 and the first surface 401A in the third direction Z satisfies: 0<H1≤300 µm, for example, H1 may be 1 µm, 10 µm, 30 µm, 50 µm, 70 µm, 90 µm, 100 µm, 110 µm, 130 µm, 150 µm, 170 µm, 190 µm, 200 µm, 210 µm, 230 µm, 250 µm, 270 µm, 290 µm, 300 µm, or the like; and a height difference H2 between the third surface 121 and the second surface 402A in the third direction Z satisfies: 0≤H2≤300 µm, for example, H2 may be 0, 1 µm, 10 µm, 30 µm, 50 µm, 70 µm, 90 µm, 100 µm, 110 µm, 130 µm, 150 µm, 170 µm, 190 µm, 200 µm, 210 µm, 230 µm, 250 µm, 270 µm, 290 µm, and 300 µm.

If H1>300 µm, difficulty of bonding the mesh body 1 to the outer frame 40 is increased, and there is a risk that the mesh body 1 and the first portion 401 are separated from each other due to bonding failure. Therefore, 0<H1≤300 µm, so that the height difference exists between the third surface 121 and the first surface 401A, which reduces the risk that the first surface 401A abuts against the uncured glue on the first solar cell 10 to improve accuracy of the glue printing amount of the first solar cell 10, reduces the risk that the glue is cured on the first surface 401A to damage the solar cell 10 below the first surface 401A, and meanwhile reduces the difficulty of bonding the mesh body 1 and the outer frame 40, to improve bonding stability and reliability of the mesh body 1 and the first portion 401.

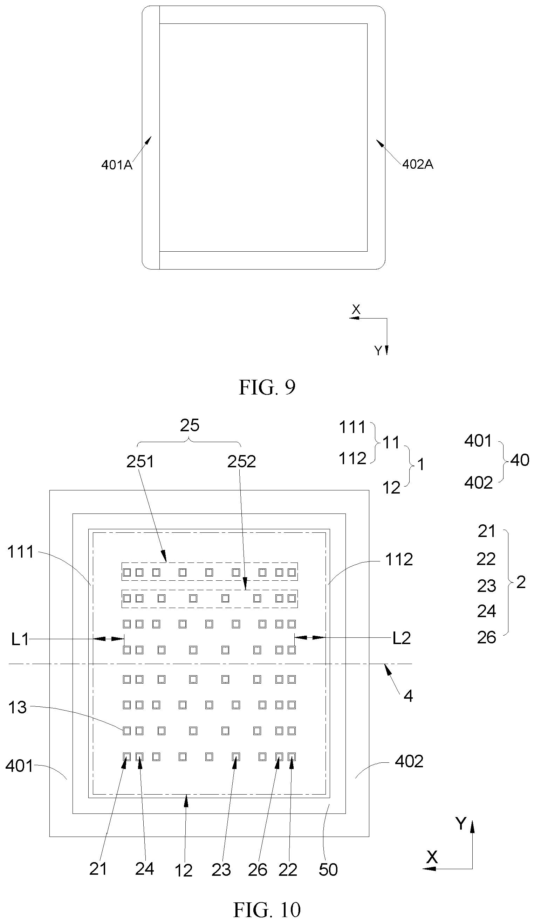

As shown in FIG. 6, 0<H2≤300 µm, so that the height difference exists between the third surface 121 and the second surface 402A, which reduces the risk that the second surface 402A abuts against the third surface to reduce the risk of damaging the solar cell 10 below the third surface 121, and meanwhile reduces the difficulty of bonding the mesh body 1 and the outer frame 40 to improve bonding stability and reliability of the mesh body 1 and the second portion 402. As shown in FIG. 9, when H2=0, a surface structure of a side of the outer frame 40 close to the solar cell 10 is substantially as shown in FIG. 9. That is, the first portion 401 is partially thinned, so that a height difference exists between the first surface 401A and the second surface 402A, and the second surface 402A and the third surface 121 are located in the same plane, so as to increase a bonding area between the mesh body 1 and the second portion 402, thus improving the bonding stability and reliability of the mesh body 1 and the second portion 402. Since the solar cell 10 below the second portion 402 is not printed with glue, there is no risk that the glue adheres to the second surface 402A, so that the second surface 402A and the first surface 401A may have a height difference, or be located in the same plane, so as to increase flexibility of the configuration of the glue printing mesh 80.

Furthermore, when 0<H1≤300 µm and 0<H2≤300 µm, height differences exist between the third surface 121 and the first surface 401A and between the third surface 121 and the second surface 402A, so that the movement direction of the solar cell 10 can be the positive direction or the negative direction of the first direction X shown in FIG. 6, so as to flexibly adjust a feeding position and the movement direction of the solar cell 10, thus facilitating an improvement of flexibility of an arrangement position of the glue printing device.

As shown in FIG. 5 and FIG. 6, in the first direction X, at a side close to the first portion 401, a distance L1 between the first hole channel 21 and an edge of the glue printing region 12 satisfies: 2 mm≤L1≤7 mm, for example, 2 mm, 2.1 mm, 2.3 mm, 2.5 mm, 2.7 mm, 2.9 mm, 3 mm, 3.1 mm, 3.3 mm, 3.5 mm, 3.7 mm, 3.9 mm, 4 mm, 4.1 mm, 4.3 mm, 4.5 mm, 4.7 mm, 4.9 mm, 5 mm, 5.1 mm, 5.3 mm, 5.5 mm, 5.7 mm, 5.9 mm, 6 mm, 6.1 mm, 6.3 mm, 6.5 mm, 6.7 mm, 6.9 mm, 7 mm, or the like. As shown in FIG. 5 and FIG. 6, in the first direction X, at a side close to the second portion 402, a distance L2 between the second hole channel 22 and an edge of the glue printing region 12 satisfies: 2 mm≤L2≤7 mm, for example, 2 mm, 2.1 mm, 2.3 mm, 2.5 mm, 2.7 mm, 2.9 mm, 3 mm, 3.1 mm, 3.3 mm, 3.5 mm, 3.7 mm, 3.9 mm, 4 mm, 4.1 mm, 4.3 mm, 4.5 mm, 4.7 mm, 4.9 mm, 5 mm, 5.1 mm, 5.3 mm, 5.5 mm, 5.7 mm, 5.9 mm, 6 mm, 6.1 mm, 6.3 mm, 6.5 mm, 6.7 mm, 6.9 mm, 7 mm, or the like. Or, as shown in FIG. 7 and FIG. 8, 60 mm≤L2≤65 mm, for example, 60 mm, 60.1 mm, 60.3 mm, 60.5 mm, 60.7 mm, 60.9 mm, 61 mm, 61.1 mm, 61.3 mm, 61.5 mm, 61.7 mm, 61.9 mm, 62 mm, 62.1 mm, 62.3 mm, 62.5 mm, 62.7 mm, 62.9 mm, 63 mm, 63.1 mm, 63.3 mm, 63.5 mm, 63.7 mm, 63.9 mm, 64 mm, 64.1 mm, 64.3 mm, 64.5 mm, 64.7 mm, 64.9 mm, 65 mm, or the like.

If L1<2 mm, the distance between the mesh hole 2 and the edge of the glue printing region 12 is small, so that a deformation degree of the mesh body 1 at this position is weak, a required downward pressure of the scraper 90 is large, thereby increasing debugging difficulty of the downward pressure of the glue printing device. If L1>7 mm, the distance between the mesh hole 2 and the edge of the glue printing region 12 is large, there is a risk that the third surface 121 is in contact with the uncured glue on the adjacent solar cell 10. Therefore, when 2 mm≤L1≤7 mm, the debugging difficulty of the downward pressure of the glue printing device is reduced, and a risk of glue scraping of the third surface 121 is reduced, thereby improving a processing yield of the photovoltaic module.

If 2 mm≤L2≤7 mm, an overall dimension of the mesh body 1 in the first direction X is small, which is beneficial to reducing a material cost of the mesh body 1. Meanwhile, the small distance L2 reduces a risk that the third surface 121 abuts against the adjacent solar cell 10 not printed with glue, thereby reducing a risk that the third surface 121 damages the solar cell 10 not printed with glue, so as to improve the yield of the photovoltaic module.

If 60 mm≤L2≤65 mm, the required downward pressure of the scraper 90 at this position is reduced, thereby reducing the debugging difficulty of the downward pressure of the glue printing device. At the same time, the downward pressing force of the scraper 90 is smaller, which reduces glue output at the outermost mesh hole 2 at a side close to the second portion 402 and reduces a risk of a larger shielding area of the solar cell 10 caused by overflowing of a large amount of glue, thereby helping to improve photoelectric conversion efficiency of the solar cell 10. In addition, after the scraper 90 passes through the last one mesh hole 2, a movement distance of the scraper 90 in the first direction X is increased, which reduces a risk of damage to the scraper 90 caused by abutment of the scraper 90 against the outer frame 40, thereby prolonging the service life of the scraper 90 and the outer frame 40.

When 2 mm≤L1≤7 mm, in a plane defined by the first direction X and the third direction Z, a cross-sectional profile of the first portion 401 of the outer frame 40 is L-shaped, so that an avoidance region is formed at a side of the first portion 401 close to the scraper 90, which reduces a risk of damage caused by abutment of the scraper 90 against the first portion 401, thereby prolonging the service life of the scraper 90 and the outer frame 40.

When 2 mm≤L2≤7 mm, in a plane defined by the first direction X and the third direction Z, a cross-sectional profile of the second portion 402 of the outer frame 40 is L-shaped, so that an avoidance region is formed at a side of the second portion 402 close to the scraper 90, which reduces a risk of damage caused by abutment of the scraper 90 against the second portion 402, thereby prolonging the service life of the scraper 90 and the outer frame 40. When 2 mm≤L1≤7 mm and 2 mm≤L2≤7 mm, a dimension of the entire glue printing region 12 in the first direction X ranges from 90 mm to 100 mm, and the dimension of the glue printing region 12 in the first direction X complies with a dimension of the solar cell 10 in the first direction X.

When 60 mm≤L2≤65 mm, in the plane defined by the first direction X and the third direction Z, a cross-sectional profile of the second portion 402 of the outer frame 40 may be rectangular or L-shaped, the rectangular cross-sectional profile of the second portion 402 can reduce processing difficulty and a processing cost of the outer frame 40, and the L-shaped cross-sectional profile of the second portion 402 reduces a risk of a damage caused by abutment of the scraper 90 against the second portion 402, thereby prolonging the service life of the scraper 90 and the outer frame 40. When 2 mm≤L1≤7 mm and 60 mm≤L2≤65 mm, the dimension of the entire glue printing region 12 in the first direction X ranges from 140 mm to 145 mm.

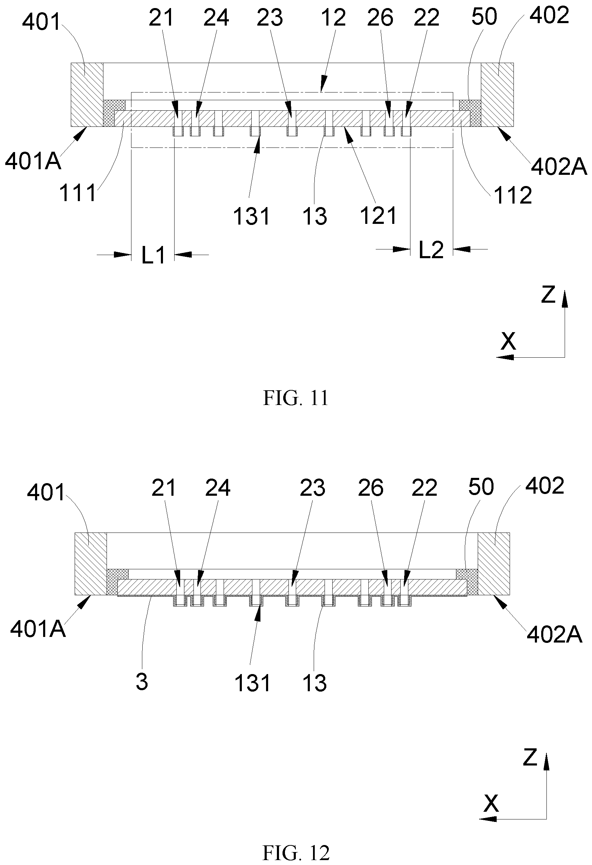

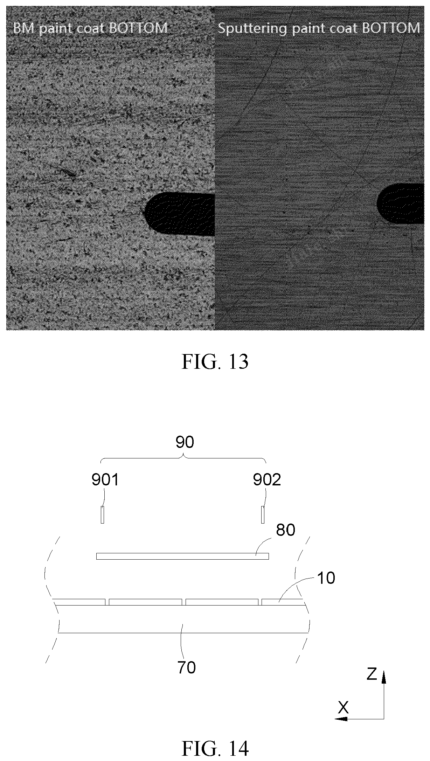

In any one of the embodiments described above, as shown in FIG. 12, when a part of the glue printing region 12 protrudes from the outer frame 40 to form the protruding portion, the third surface 121 of the glue printing region 12 is covered by a hydrophobic coating 3. That is, the hydrophobic coating 3 is arranged on a surface of the protruding portion. During the manufacturing of the mesh body 1, by magnetron sputtering, a device such as a vacuum furnace is used to enrich niobium pentoxide, silicon oxide, aluminum oxide, and fluoride onto the third surface 121 to form the hydrophobic coating 3, and a contact angle between the glue and the third surface 121 is increased. Compared with the BM coating formed by enriching fluoride onto the third surface 121 by physical infiltration in the prior art, as shown in FIG. 13, the hydrophobic coating 3 formed by magnetron sputtering in the present disclosure has low surface roughness, thereby reducing a residual amount of the glue on the third surface 121, so that a cleaning cycle of the third surface 121 is increased to 6 h to 8 h for one cleaning, which prolongs the cleaning cycle of the glue printing mesh 80, thereby reducing a number of cleanings and improving glue printing efficiency of the glue printing device.

A thickness of the hydrophobic coating 3 ranges from 80 nm to 120 nm, for example, 80 nm, 85 nm, 90 nm, 95 nm, 100 nm, 105 nm, 110 nm, 115 nm, 120 nm, or the like, to reduce manufacturing difficulty and a material cost of the hydrophobic coating 3.

In another possible design, as shown in FIG. 10 and FIG. 11, the mesh body 1 includes a protruding rib 13, the protruding rib 13 is located on a side of the glue printing region 12 close to the solar cell 10 in the third direction Z, the mesh hole 2 passes through the glue printing region 12 and the protruding rib 13, and the protruding rib 13 is the above-mentioned protruding portion.

By arranging the protruding rib 13 to form the protruding portion, the third surface 121 of the glue printing region 12 and the first surface 401A and the second surface 402A of the outer frame 40 can be located in a same plane, while a risk of glue rubbing of the glue printing mesh 80 is reduced, thereby increasing a bonding area of the mesh body 1 and the outer frame 40, thus facilitating an improvement of bonding stability and reliability of the mesh body 1 and the outer frame 40.

The protruding ribs 13 are arranged at intervals in the first direction X and the second direction Y, so that the mesh body 1 includes local protruding structures at the positions of the mesh holes 2, thereby reducing an influence of the protruding ribs 13 on deformation difficulty of the mesh body 1, thus reducing the required downward pressure of the scraper 90, and reducing the debugging difficulty of the glue printing device.

A height of the protruding rib 13 in the third direction Z ranges from 200 µm to 350 µm, for example, 200 µm, 210 µm, 220 µm, 230 µm, 240 µm, 250 µm, 260 µm, 270 µm, 280 µm, 290 µm, 300 µm, 310 µm, 320 µm, 330 µm, 340 µm, 350 µm, or the like. If the height of the protruding rib 13 is smaller than 200 µm, a risk that the first surface 401A and the second surface 402A abut against the adjacent solar cell 10 is high; and if the height of the protruding rib 13 is larger than 350 µm, structural strength of the protruding rib 13 is weak, and there is a risk that the protruding rib 13 is bent and deformed when the scraper 90 presses down the mesh body 1. Therefore, the height of the protruding rib 13 ranges from 200 µm to 350 µm, which can reduce a risk of glue rubbing of the glue printing mesh 80, and facilitate an improvement of the structural strength of the protruding rib 13, thereby improving a glue printing yield of the glue printing device.

As shown in FIG. 10 and FIG. 11, in the first direction X, at a side close to the first portion 401, a distance L1 between the mesh hole 2 and an edge of the glue printing region 12 satisfies: 60 mm≤L1≤65 mm, for example, 60 mm, 60.1 mm, 60.3 mm, 60.5 mm, 60.7 mm, 60.9 mm, 61 mm, 61.1 mm, 61.3 mm, 61.5 mm, 61.7 mm, 61.9 mm, 62 mm, 62.1 mm, 62.3 mm, 62.5 mm, 62.7 mm, 62.9 mm, 63 mm, 63.1 mm, 63.3 mm, 63.5 mm, 63.7 mm, 63.9 mm, 64 mm, 64.1 mm, 64.3 mm, 64.5 mm, 64.7 mm, 64.9 mm, 65 mm, or the like. In the first direction X, at a side close to the second portion 402, a distance L2 between the mesh hole 2 and an edge of the glue printing region 12 satisfies: 60 mm≤L2≤65 mm, for example, 60 mm, 60.1 mm, 60.3 mm, 60.5 mm, 60.7 mm, 60.9 mm, 61 mm, 61.1 mm, 61.3 mm, 61.5 mm, 61.7 mm, 61.9 mm, 62 mm, 62.1 mm, 62.3 mm, 62.5 mm, 62.7 mm, 62.9 mm, 63 mm, 63.1 mm, 63.3 mm, 63.5 mm, 63.7 mm, 63.9 mm, 64 mm, 64.1 mm, 64.3 mm, 64.5 mm, 64.7 mm, 64.9 mm, 65 mm, or the like.

When 60 mm≤L1≤65 mm, and 60 mm≤L2≤65 mm, the required downward pressure of the scraper 90 at an edge of the glue printing region 12 is reduced, thereby reducing the debugging difficulty of the downward pressure of the glue printing device. Meanwhile, the small downward pressure of the scraper 90 reduces the amount of glue output at the mesh hole 2 close to the edge of the glue printing region 12, and reduces a risk that the shielded area on the solar cell 10 is large due to overflowing of a large amount of glue at this position, thereby facilitating the improvement of the photoelectric conversion efficiency of the solar cell 10. Furthermore, in the first direction X, movement spaces of the scraper 90 at the edges of two sides of the glue printing region 12 are increased, and a risk of damage to the scraper caused by abutment of the scraper 90 against the outer frame 40 is reduced, thereby prolonging the service life of the scraper 90 and the outer frame 40.

A surface of the protruding rib 13 for abutting against the solar cell 10 is a fourth surface 131. In a possible design, only the fourth surface 131 is covered by the hydrophobic coating 3 formed in the magnetron sputtering manner. That is, only the surface of the protruding portion is provided with the hydrophobic coating 3, thereby reducing a residual amount of the glue on the fourth surface 131, so that a cleaning cycle of the third surface 121 is increased to 6 h to 8 h for one cleaning, which prolongs the cleaning cycle of the glue printing mesh 80, thereby reducing a number of cleanings and improving glue printing efficiency of the glue printing device.

In another possible design, each of the third surface 121 and the fourth surface 131 is provided with the hydrophobic coating 3 formed in the magnetron sputtering manner. That is, each of the surfaces of the glue printing region 12 and the protruding portion is provided with the hydrophobic coating 3, thereby reducing the residual amounts of the glue on the third surface 121 and the fourth surface 131, so that the cleaning cycles of the third surface 121 and the fourth surface 131 are increased to 6 h to 8 h for one cleaning, which prolongs the cleaning cycle of the glue printing mesh 80, thereby reducing a number of cleanings and improving glue printing efficiency of the glue printing device.

In any one of the embodiments described above, an overall dimension of the glue printing region 12 in the second direction Y ranges from 300 mm to 400 mm, for example, 300 mm, 310 mm, 320 mm, 330 mm, 340 mm, 350 mm, 360 mm, 370 mm, 380 mm, 390 mm, 400 mm, or the like. In the second direction Y, a distance between the outermost mesh hole 2 and an edge of the glue printing region 12 ranges from 70 mm to 80 mm, for example, 71 mm, 72 mm, 73 mm, 74 mm, 75 mm, 76 mm, 77 mm, 78 mm, 79 mm, 80 mm, or the like.

In a possible design, as shown in FIG. 4, one glue printing mesh 80 can cover one solar cell 10. That is, the glue printing mesh 80 is provided with only one glue printing region 12, so as to reduce the overall dimension of the glue printing mesh 80.

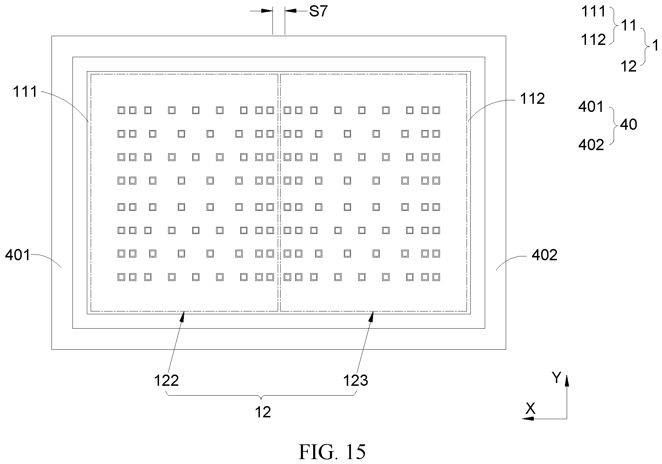

In another possible design, as shown in FIG. 14, one glue printing mesh 80 can cover at least two solar cells 10. That is, as shown in FIG. 15, the glue printing region 12 at least includes a third region 122 and a fourth region 123 arranged in the first direction X, the third region 122 and the fourth region 123 correspond to two adjacent solar cells 10, and when the glue printing device performs the glue printing operation, the glue printing device can print glue on two solar cells 10 simultaneously in one glue printing stroke, so as to improve the glue printing efficiency of the glue printing device, thereby facilitating realization of matched use of the glue printing device and a high-speed welding machine.

A minimum distance S7 between the second hole channel 22 in the third region and the first hole channel 21 in the fourth region satisfies: 15 mm≤S7≤25 mm, for example, 15 mm, 16 mm, 17 mm, 18 mm, 19 mm, 20 mm, 21 mm, 22 mm, 23 mm, 24 mm, 25 mm, or the like.

If S7<15 mm, strength of the mesh body 1 between the second hole channel 22 in the third region and the first hole channel 21 in the fourth region is weak, and there is a risk of damage to the mesh body when the scraper 90 presses down. If S7>25 mm, the overall dimension of the mesh body 1 is increased, thereby increasing the cost of the glue printing device, at the same time, there is a higher risk of deviation of relative positions of the fourth region 123 and the solar cell 10. Therefore, when 15 mm≤S7≤25 mm, strength of the mesh body 1 is improved, thereby prolonging the service life of the glue printing device, at the same time, accuracy of the relative positions of the fourth region 123 and the solar cell 10 is improved.

In a third aspect, some embodiments of the present disclosure provide a glue printing process of a photovoltaic module. The photovoltaic module is the photovoltaic module in any one of the embodiments described above. The glue printing device is the glue printing device in any one of the embodiments described above. The glue printing process of a photovoltaic module includes: arranging a plurality of solar cells at intervals along the first direction X, and placing the solder strip on the plurality of solar cells; pre-soldering the plurality of solar cells and the solder strip at solder points to form a pre-fixed solar cell string; and placing the pre-fixed solar cell string on a glue printing device, the glue printing device being the glue printing device in any one of the embodiments, and the glue printing device printing glue on a surface where the pre-fixed solar cell string is placed to form the glue dots described above.

The process of the glue printing device printing glue on a surface where the pre-fixed solar cell string is placed to form the glue dots described above includes: placing the pre-fixed solar cell string on a base, the pre-fixed solar cell string being located between the glue printing mesh and the base along a third direction Z; moving the glue printing mesh along the third direction Z to cause a surface of the glue printing mesh to contact the solder strip; moving a scraper along the third direction Z to make the scraper abut against a surface of the glue printing mesh facing away from the solar cells, in such a manner that the glue printing mesh is driven by the scraper to partially deform towards the solar cells; moving the scraper along the first direction X, in such a manner that the glue is driven by the scraper to flow through mesh holes to reach surfaces of the solder strip and the solar cells; after the scraper completes one printing stroke, moving the scraper and the glue printing mesh along the third direction Z towards a direction away from the solar cells; and moving the pre-fixed solar cell string to a curing device, to facilitate curing of the glue to form the glue dots 60.

When one glue printing mesh 80 covers at least two solar cells 10, the process of moving the scraper along the first direction X, in such a manner that the glue is driven by the scraper to flow through mesh holes to reach surfaces of the solder strip and the solar cells includes: moving the scraper from the connection region to the third region along the first direction X and continuously moving the scraper, in such a manner that the glue flows through the mesh holes in the third region to reach the surfaces of the solder strip and the first solar cell; and moving the scraper from the third region to the fourth region along the first direction X and continuously moving the scraper, in such a manner that the glue flows through the mesh holes in the fourth region to reach the surfaces of the solder strip and the second solar cell.

The above are merely preferred embodiments of the present disclosure and are not intended to limit the present disclosure. For those skilled in the art, various modifications and variations may be made to the present disclosure. Any modifications, equivalent replacements, improvements, and the like made within a spirit and a principle of the present disclosure shall fall within a scope of the present disclosure.

## Claims

1. A glue printing mesh (80), comprising:
an outer frame (40);
a mesh body (1), wherein the outer frame (40) is arranged at an edge of the mesh body (1); the mesh body (1) comprises a connection region (11) and a glue printing region (12), the connection region (11) surrounds an outer side of the glue printing region (12), and the connection region (11) is fixedly connected to the outer frame (40); and the mesh body (1) comprises a protruding portion, the protruding portion is located on a side of the glue printing region (12) in a thickness direction of the glue printing mesh (80), and a side of the protruding portion facing away from the mesh body (1) is configured to be in contact with a solar cell (10); and
mesh holes (2) formed in the glue printing region (12), wherein the mesh holes (2) pass through the mesh body (1) in the thickness direction of the glue printing mesh (80).

2. The glue printing mesh according to claim 1, wherein
in the thickness direction of the glue printing mesh (80), a part of the glue printing region (12) protrudes from the outer frame (40) to form the protruding portion;
the outer frame (40) comprises a first portion (401) and a second portion (402), and the first portion (401) and the second portion (402) are located at two sides of the mesh body (1) in a first direction (X) perpendicular to the thickness direction of the glue printing mesh (80);
the first portion (401) is provided with a first surface (401A), the second portion (402) is provided with a second surface (402A), the glue printing region (12) is provided with a third surface (121), and in the thickness direction of the glue printing mesh (80), the first surface (401A), the second surface (402A) and the third surface (121) are all located on a side of the glue printing mesh (80) facing the solar cell (10); and
a height difference H1 between the third surface (121) and the first surface (401A) in the thickness direction of the glue printing mesh (80) satisfies: 0<H1≤300 µm, and a height difference H2 between the third surface (121) and the second surface (402A) in the thickness direction of the glue printing mesh (80) satisfies: 0≤H2≤300 µm.

3. The glue printing mesh according to claim 2, wherein
in the first direction (X), on a side close to the first portion (401), a distance L1 between an edge of the glue printing region (12) and the mesh hole (2) closest to the edge of the glue printing region (12) satisfies: 2 mm≤L1≤7 mm; and
in the first direction (X), on a side close to the second portion (402), a distance L2 between an edge of the glue printing region (12) and the mesh hole (2) closest to the edge of the glue printing region (12) satisfies: 2 mm≤L2≤7 mm.

4. The glue printing mesh according to claim 2, wherein
in the first direction (X), on a side close to the first portion (401), a distance L1 between an edge of the glue printing region (12) and the mesh hole (2) closest to the edge of the glue printing region (12) satisfies: 2 mm≤L1≤7 mm; and
in the first direction (X), on a side close to the second portion (402), a distance L2 between an edge of the glue printing region (12) and the mesh hole (2) closest to the edge of the glue printing region (12) satisfies: 60 mm≤L2≤65 mm.

5. The glue printing mesh according to claim 1, wherein
the mesh body (1) comprises a protruding rib (13), the protruding rib (13) is located on a side of the glue printing region (12) close to the solar cell (10) in the thickness direction of the glue printing mesh (80), the mesh holes (2) pass through the glue printing region (12) and the protruding rib (13), and the protruding rib (13) is the protruding portion; and
a height of the protruding rib (13) ranges from 200 µm to 350 µm in the thickness direction of the glue printing mesh (80).

6. The glue printing mesh according to claim 5, wherein
a plurality of protruding ribs (13) are arranged at intervals in a first direction (X) and a second direction (Y) that are both perpendicular to the thickness direction of the glue printing mesh (80), the first direction (X) intersecting the second direction (Y).

7. The glue printing mesh according to claim 5, wherein
the outer frame (40) comprises a first portion (401) and a second portion (402), and the first portion (401) and the second portion (402) are located at two sides of the mesh body (1) in a first direction (X) perpendicular to the thickness direction of the glue printing mesh (80);
in the first direction (X), on a side close to the first portion (401), a distance L1 between an edge of the glue printing region (12) and the mesh hole (2) closest to the edge of the glue printing region (12) satisfies: 60 mm≤L1≤65 mm; and
in the first direction (X), on a side close to the second portion (402), a distance L2 between an edge of the glue printing region (12) and the mesh hole (2) closest to the edge of the glue printing region (12) satisfies: 60 mm≤L2≤65 mm.

8. The glue printing mesh according to claim 1, wherein a surface of the protruding portion is covered by a hydrophobic coating (3).

9. The glue printing mesh according to claim 8, wherein a thickness of the hydrophobic coating (3) ranges from 80 nm to 120 nm.

10. The glue printing mesh according to any one of claims 1 to 5,
wherein the outer frame (40) comprises a first portion (401) and a second portion (402), and the first portion (401) and the second portion (402) are located at two sides of the mesh body (1) in a first direction (X) perpendicular to the thickness direction of the glue printing mesh (80); the mesh holes (2) comprise a first hole channel (21), a second hole channel (22) and third hole channels (23); and in the first direction (X), the first hole channel (21) is located on a side of the glue printing region (12) close to the first portion (401), the second hole channel (22) is located on a side of the glue printing region (12) close to the second portion (402), the third hole channels (23) are arranged at intervals and located between the first hole channel (21) and the second hole channel (22);
a length of the first hole channel (21) in the first direction (X) ranges from 6 mm to 9 mm, and/or a length of the second hole channel (22) in the first direction (X) ranges from 6 mm to 9 mm.

11. The glue printing mesh according to any one of claims 1 to 5,
wherein the outer frame (40) comprises a first portion (401) and a second portion (402), and the first portion (401) and the second portion (402) are located at two sides of the mesh body (1) in a first direction (X) perpendicular to the thickness direction of the glue printing mesh (80); the mesh holes (2) comprise a first hole channel (21), a second hole channel (22) and third hole channels (23); and in the first direction (X), the first hole channel (21) is located on a side of the glue printing region (12) close to the first portion (401), the second hole channel (22) is located on a side of the glue printing region (12) close to the second portion (402), the third hole channels (23) are arranged at intervals and located between the first hole channel (21) and the second hole channel (22);
the mesh holes (2) further comprise a fourth hole channel (24) and a fifth hole channel (26); and in the first direction (X), the fourth hole channel (24) and the fifth hole channel (26) are located between the first hole channel (21) and the second hole channel (22), the third hole channels (23) are located between the fourth hole channel (24) and the fifth hole channel (26), a length of the first hole channel (21) in the first direction (X) ranges from 0.2 mm to 0.4 mm, a length of the fourth hole channel (24) in the first direction (X) ranges from 0.2 mm to 0.4 mm, a length of the second hole channel (22) in the first direction (X) ranges from 0.2 mm to 0.4 mm, and a length of the fifth hole channel (26) in the first direction (X) ranges from 0.2 mm to 0.4 mm.

12. The glue printing mesh according to any one of claims 1 to 5, wherein
the mesh holes (2) are arranged at intervals in a first direction (X) to form unit rows (25), and the unit rows (25) are arranged at intervals in a second direction (Y), the first direction (X) intersecting the second direction (Y) and both the first direction (X) and the second direction (Y) being perpendicular to the thickness direction of the glue printing mesh (80);
four or more mesh holes (2) are provided in each unit row of the unit rows (25); and
the glue printing mesh (80) has a central axis (4) extending along the first direction (X), and the unit rows (25) are symmetrically distributed about the central axis (4).

13. The glue printing mesh according to claim 12, wherein adjacent unit rows (25) are respectively defined as a first unit row (251) and a second unit row (252), and the mesh holes (2) in the first unit row (251) are directly opposite to the mesh holes (2) in the second unit row (252) one by one in the second direction (Y).

14. The glue printing mesh according to claim 12, wherein adjacent unit rows (25) are respectively defined as a first unit row (251) and a second unit row (252), and at least part of the mesh holes (2) in the first unit row (251) is not aligned with at least part of the mesh holes (2) in the second unit row (252) in the second direction (Y).

15. The glue printing mesh according to claim 12, wherein the outer frame (40) comprises a first portion (401) and a second portion (402), and the first portion (401) and the second portion (402) are located at two sides of the mesh body (1) in the first direction (X); the mesh holes (2) in each unit row (25) at least include a first hole channel (21), a second hole channel (22) and third hole channels (23), the first hole channel (21) is located on a side of the glue printing region (12) close to a first portion (401), the second hole channel (22) is located on a side of the glue printing region (12) close to a second portion (402), and the third hole channels (23) are arranged at intervals and located between the first hole channel (21) and the second hole channel (22); the first hole channel (21) in the first unit row (251) is aligned with the first hole channel (21) in the second unit row (252) in the second direction (Y), the second hole channel (22) in the first unit row (251) is aligned with the second hole channel (22) in the second unit row (252) in the second direction (Y), and the third hole channel (23) in the first unit row (251) is not aligned with the third hole channel (23) in the second unit row (252) in the second direction (Y).
